# FASCICULE DE BREVET EUROPEEN

(11) **EP 3 125 320 B1**
(45) Date de publication et mention de la délivrance du brevet: **26.09.2018**
(21) Numéro de dépôt: 16181798.6
(22) Date de dépôt: 28.07.2016
(51) Int. Cl.: H01L 45/00, H01L 27/24

(54) **DISPOSITIF MÉMOIRE**
SPEICHERVORRICHTUNG
MEMORY DEVICE

(30) Priorité: 31.07.2015 FR 1557363
(43) Date de publication de la demande: 01.02.2017
(73) Titulaire: COMMISSARIAT À L'ÉNERGIE ATOMIQUE ET AUX ÉNERGIES ALTERNATIVES, 75015 Paris (FR)
(72) Inventeur: CHARPIN-NICOLLE, Christelle, 38120 FONTANIL-CORNILLON (FR); JALAGUIER, Eric, 38410 SAINT MARTIN D'URIAGE (FR); PERNIOLA, Luca, 38360 NOYAREY (FR); POUPINET, Ludovic, 38360 SASSENAGE (FR); TRAORE, Boubacar, 38100 GRENOBLE (FR)
(74) Mandataire: Hautier, Nicolas

(56) Documents cités:
- US-A1- 2011 017 977
- US-A1- 2015 041 748
- US-A1- 2015 171 095

## Description

### DOMAINE DE L'INVENTION

La présente invention concerne, en général, un dispositif à mémoire résistive, et plus particulièrement, un dispositif à mémoire résistive non volatile et son procédé de réalisation.

### ARRIERE-PLAN TECHNOLOGIQUE

Les mémoires résistives de type OxRRAM (acronyme en anglais pour « Oxide-Based Resistive Random Access Memories ») comprenant typiquement une couche d'oxyde métallique, sont préférentiellement choisies pour les applications non-volatiles, dans le but de remplacer les mémoires de type Flash. Elles présentent notamment pour avantage d'être compatibles avec le procédé de fin de ligne (acronyme BEOL en anglais pour « Back-End Of Line ») de la technologie CMOS (acronyme en anglais pour « Complementary Metal-Oxide-Semiconductor »). Les mémoires résistives OxRRAM sont des dispositifs comprenant notamment une couche d'oxyde métallique disposée entre deux électrodes. La résistance électrique de tels dispositifs peut être modifiée par des opérations d'écriture et d'effacement. Ces opérations d'écriture et d'effacement permettent de faire passer le dispositif à mémoire résistive OxRAM d'un état basse résistance LRS (acronyme en anglais pour « Low Resistive State ») à un état haute résistance HRS (acronyme en anglais pour « High Resistive State »), et inversement.
De cycle en cycle, les résistances des états basse résistance LRS et haute résistance HRS ne montrent pas une très bonne reproductibilité des performances. Une variabilité des performances cycle-à-cycle est en effet observée. Cette variabilité est particulièrement importante pour l'état de haute résistance HRS, induisant une diminution de la fenêtre de programmation, voire une perte totale de la fenêtre de programmation. Ce problème de variabilité est aujourd'hui un réel frein à l'industrialisation.

Ce souci demeure malgré de nombreux efforts réalisés dans les domaines des procédés de réalisation de dispositifs à mémoire résistive et de méthodes de programmation.

De nombreuses études ont été réalisées afin de réduire la variabilité des performances électriques par la réduction des dimensions du dispositif mémoire. En particulier, il a été montré dans la publication : « Conductive Filament Control in Highly Scalable Unipolar Resistive Switching Devices for Low-Power and High-density Next Génération Memory», Kyung-Chang Ryoo et al., IEDM2013, qu'une solution pour réduire les dimensions du dispositif mémoire est de réduire la surface de contact entre l'une des électrodes et la couche d'oxyde.

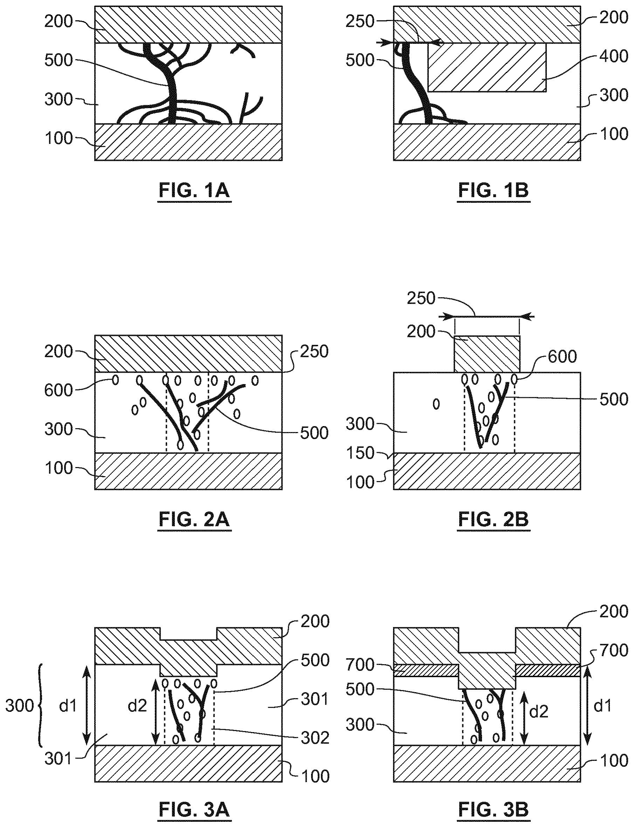

La **figure 1A** illustre un dispositif mémoire comprenant une couche d'oxyde métallique 300 disposée entre une première électrode 100 et une deuxième 200 électrode, selon l'art antérieur. Des filaments conducteurs 500 sont créés au travers de la couche d'oxyde 300. Il apparaît que les filaments conducteurs 500 peuvent se disperser au niveau des surfaces de contact séparant chacune des électrodes 100, 200 de la couche d'oxyde 300. Cette dispersion des filaments conducteurs 500 dans la couche d'oxyde 300 peut être responsable de la variabilité des performances, observée pour les dispositifs à mémoire résistive de l'art antérieur.

La **figure 1B** illustre un dispositif mémoire comprenant une couche d'oxyde 300 disposée entre une première électrode 100 et une deuxième électrode 200, selon l'art antérieur. Le dispositif montre une surface de contact réduite entre la deuxième électrode 200 et la couche d'oxyde 300. Il apparaît que les filaments conducteurs 500 sont dirigés vers la surface de contact réduite.

L'inconvénient de ce type de dispositif mémoire est la complexité du procédé de réalisation. En effet afin de former une surface de contact réduite entre la deuxième électrode et la couche d'oxyde, il est nécessaire de recourir à des étapes multiples et donc coûteuses. Notamment, les étapes de lithographie, de dépôts, de planarisation, nécessaires à l'obtention de dimensions nanométriques au niveau du contact entre les électrodes et le matériau diélectrique sont complexes et requièrent des étapes de développement lourdes. Par ailleurs, une reprise de contact réalisée sur une petite surface entraîne inévitablement des contraintes supplémentaires au niveau de l'industrialisation.

Des dispositifs connus sont divulgués par US 2011 / 0017977 A1, US 2015 / 0041748 A1 et US 2015 / 0171095 A1.

La présente invention permet de résoudre tout ou, du moins, une partie des inconvénients des techniques actuelles. Il serait notamment avantageux de proposer une solution pour réduire voire supprimer la variabilité des performances observée cycle après cycle pour des dispositifs à mémoire résistive, tout en limitant ou évitant les inconvénients des procédés de réalisation connus de l'art antérieur mentionnés ci-dessus.

### RESUME DE L'INVENTION

La présente invention concerne un dispositif mémoire tel que défini par la revendication 1 comprenant une couche d'oxyde disposée entre une première électrode et une deuxième électrode. Avantageusement, la couche d'oxyde présente une première zone et une deuxième zone, la première zone entourant ou étant située de part et d'autre de la deuxième zone, la distance minimale d2 séparant les première et deuxième électrodes au niveau de la deuxième zone de la couche d'oxyde étant inférieure à la distance minimale d1 séparant les deux électrodes au niveau de la première zone de la couche d'oxyde.

Lorsque la surface de contact entre l'au moins une électrode parmi la première électrode et la deuxième électrode et la couche d'oxyde est importante, le nombre de chemins parasites de filaments conducteurs qui peuvent être crées lors d'étapes de programmation est élevé ; ce qui peut générer une variabilité importante des performances cycle-à-cycle.

Avantageusement, et selon un mode de réalisation préféré mais non limitatif de l'invention, afin de réduire cette instabilité, la surface de contact entre l'au moins une électrode parmi les première et deuxième électrodes, préférentiellement choisie non inerte, c'est-à-dire ayant une forte interaction chimique avec la couche d'oxyde, et la deuxième zone de ladite couche d'oxyde est réduite. L'autre électrode parmi les deux électrodes est préférentiellement inerte, c'est-à-dire qu'elle n'est pas apte à réagir avec la couche d'oxyde.

Bien que le contrôle de la concentration en oxygène du filament conducteur permette de réaliser des cycles à bas courant et une meilleure rétention d'informations, la présente invention ne requiert pas un ajustement de l'épaisseur de la couche d'oxyde métallique (par exemple à base de TaO_{X}) formant l'une au moins des électrodes. Le contrôle de la concentration d'oxygène dans le filament conducteur est généralement difficile à observer et donc à contrôler.

Avantageusement, la présente invention présente une solution alternative ne nécessitant pas une modification de la fabrication du dispositif mémoire suite à un ajustement de la couche de TaO_{X} par exemple.

De manière particulièrement avantageuse, la présente invention permet de ne pas réduire la dimension transversale (s'étendant perpendiculairement au plan du substrat) de la couche d'oxyde. Or, dans le cadre du développement de la présente invention, il a été observé que la réduction de la dimension transversale de la couche d'oxyde (comme suite, par exemple, à une gravure auto-alignée de l'une des électrodes et de la couche d'oxyde) est à éviter car cela revient à rapprocher les interfaces de la couche d'oxyde métallique avec l'oxyde de passivation qui entoure ladite couche d'oxyde. Ces interfaces pourraient jouer un rôle négatif au fonctionnement du dispositif mémoire, préférentiellement de type OxRRAM, par la création de chemins de défauts parasites près de ces interfaces. Ainsi, la présente invention permet avantageusement de conserver une certaine proportion entre la surface d'au moins une électrode parmi les première et deuxième électrodes et la surface de la couche d'oxyde métallique. Le problème principal est que lorsqu'on réduit les dimensions de la cellule mémoire par lithographie et/ou par gravure, la reprise de contact en haut du point mémoire n'est pas aisée ; cela nécessite des étapes de lithographie avec un bon contrôle des performances de superposition (en anglais « overlay »).

La synergie, existant entre les dimensions de surfaces de contact entre l'au moins une électrode parmi les première et deuxième électrodes et les première et deuxième zones ainsi qu'entre les distances d1 et d2, permet de surmonter les problèmes d'instabilité (ou variabilité) cycles après cycles en agissant sur le contrôle, et plus précisément sur le confinement, du filament conducteur dans la deuxième zone.

Avantageusement, la présente invention permet de confiner la zone de formation du filament conducteur, tout en conservant des surfaces d'électrodes en regard de grandes dimensions, lesquelles électrodes seront plus facilement réalisables technologiquement.

Selon un autre mode de réalisation, l'invention porte sur un procédé de réalisation d'un dispositif mémoire tel que défini par la revendication 14 comprenant la formation d'une couche d'oxyde disposée entre une première électrode et une deuxième électrode. Selon un mode de réalisation préféré mais non limitatif de l'invention, l'une au moins des deux électrodes est une électrode non inerte, c'est-à-dire apte à réagir avec la couche d'oxyde de sorte à créer des lacunes d'oxygène ou défauts dans ladite couche d'oxyde lorsqu'une tension est appliquée au dispositif.
Avantageusement, la formation de la couche d'oxyde est réalisée de sorte à ce que la couche d'oxyde présente une première zone et une deuxième zone, la première zone entourant ou étant située de part et d'autre de la deuxième zone, la distance minimale d2 séparant les deux électrodes au niveau de la deuxième zone de la couche d'oxyde étant inférieure à la distance minimale d1 séparant les deux électrodes au niveau de la première zone de la couche d'oxyde.

La présente invention propose un procédé simple, permettant de relâcher les contraintes au niveau de la reprise de contact en haut du point mémoire (pas d'étape de lithographie coûteuse), tout en minimisant la zone de formation du filament conducteur

Un autre objet de la présente invention concerne un dispositif microélectronique comprenant une pluralité de dispositifs mémoire selon l'invention. Par dispositif microélectronique, on entend tout type de dispositif réalisé avec des moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...)

### BREVE INTRODUCTION DES FIGURES

D'autres caractéristiques, buts et avantages de la présente invention apparaitront à la lecture de la description détaillée qui suit, en regard des dessins annexés, donnés à titre d'exemples, non limitatifs, et sur lesquels :
- La FIGURE 1A illustre un dispositif mémoire comprenant une couche d'oxyde métallique disposée entre deux électrodes selon l'art antérieur. Des filaments conducteurs sont créés au travers de la couche d'oxyde.
- La FIGURE 1B illustre un dispositif mémoire comprenant une couche d'oxyde disposée entre deux électrodes selon l'art antérieur. Le dispositif montre une surface de contact réduite entre l'une des électrodes et la couche d'oxyde ; des filaments conducteurs étant formés entre les électrodes et dirigés vers la surface de contact réduite.
- La FIGURE 2A illustre un exemple de dispositif mémoire comprenant une électrode, de préférence non inerte, apte à créer des lacunes d'oxygène ou défauts dans la couche d'oxyde à partir de ladite électrode non inerte. Les filaments conducteurs possiblement formés sont dispersés au travers de la couche d'oxyde.
- La FIGURE 2B illustre un exemple de dispositif mémoire comprenant une électrode, de préférence non inerte, apte à créer des lacunes d'oxygène ou défauts dans la couche d'oxyde à partir de ladite électrode non inerte. Les filaments conducteurs possiblement formés sont confinés grâce à la réduction de la surface de contact entre une électrode et la couche d'oxyde.
- La FIGURE 3A illustre un dispositif mémoire, selon un exemple de réalisation de la présente invention, comprenant une première région où les électrodes sont séparées d'une distance d1 et une deuxième région où les électrodes sont séparées d'une distance d2 ; la distance d2 étant inférieure à la distance d1, ce qui permet de confiner les filaments conducteurs dans la deuxième région.
- La FIGURE 3B illustre un dispositif mémoire, selon un autre exemple de réalisation de la présente invention, comprenant une couche intermédiaire non conductrice entre l'une des électrodes et la couche d'oxyde. La distance d2 est inférieure à la distance d1, ce qui permet de confiner les filaments conducteurs dans la deuxième région.
- Les FIGURES 4A à 4D illustrent les étapes d'un exemple de procédé de réalisation du dispositif mémoire présenté sur la figure 3A selon la présente invention.
- La FIGURE 5A illustre un graphe représentant la tension de forming (c'est-à-dire la tension nécessaire pour avoir la première formation du filament conducteur) pour différentes épaisseurs de la couche d'oxyde de type HfO2, en fonction de la surface du dispositif.
- La FIGURE 5B est une illustration du dispositif mémoire utilisé pour réaliser le graphe de la figure 5A.
- La FIGURE 6A est un agrandissement de la figure 5A.
- La FIGURE 6B est une illustration du dispositif mémoire utilisé pour expliquer le graphe de la figure 6A.
- Les FIGURES 7A à 7C illustrent des graphes représentant une tension en fonction de la surface du dispositif mémoire, pour différentes épaisseurs de la couche d'oxyde.
- Les FIGURES 8A à 8F illustrent un exemple de réalisation d'une zone amincie localisée de l'oxyde en utilisant la lithographie dite « DSA » (acronyme en anglais pour « Direct Self Aligned ») à l'aide de copolymères de type di-blocs.
- Les FIGURES 9A à 9D illustrent un autre exemple de réalisation d'un dispositif mémoire selon l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différentes couches et substrats peuvent ne pas être représentatives de la réalité.

### DESCRIPTION DETAILLEE

Avant d'entamer une revue détaillée de modes de réalisation de l'invention, sont énoncées ci-après des caractéristiques optionnelles qui peuvent éventuellement être utilisées suivant toute association ou alternativement :
- Selon un mode de réalisation particulier, la couche d'oxyde comprend une première couche d'oxyde et une deuxième couche d'oxyde et la distance minimale d2 séparant les première et deuxième électrodes au niveau de la deuxième zone est égale à l'épaisseur de la deuxième couche d'oxyde. La formation de la deuxième zone est réalisée de sorte à ce que la distance minimale d2 séparant les première et deuxième électrodes au niveau de la deuxième zone soit égale à l'épaisseur de la deuxième couche d'oxyde. De manière particulièrement avantageuse, ce mode de réalisation comprenant une première couche d'oxyde et une deuxième couche d'oxyde propose un dispositif où la première couche d'oxyde est complètement retirée dans la zone amincie, avant que soit déposée une deuxième couche d'oxyde de l'épaisseur d2 souhaitée. Ainsi, la couche d'oxyde, c'est-à-dire la deuxième couche d'oxyde, de la zone amincie sera « intègre » et pas modifiée potentiellement en surface par la chimie de gravure utilisée lors d'étapes ultérieures du procédé.
- le ratio entre la distance d2 et la distance d1 est compris entre 0,2 et 0,7, selon un mode de réalisation particulier réalisé à partir d'un empilement comprenant de l'oxyde d'hafnium (HfO2) comme oxyde métallique et du titane (Ti), d'une épaisseur de 10 nm, comme électrode active (réservoir d'oxygène).
- le ratio entre la surface d'au moins une électrode parmi les première et deuxième électrodes située au regard de la deuxième zone et la surface de l'au moins une électrode parmi les première et deuxième électrodes située au regard de la première zone est compris entre 0,0001 et 0,5. Ce ratio concerne, un mode de réalisation particulier réalisé à partir d'un empilement comprenant de l'oxyde métallique à base d'oxyde d'hafnium (Hf02) et du titane (Ti), d'une épaisseur de 10nm, comme électrode active.
- Selon un mode de réalisation, les première et deuxième électrodes s'étendent principalement dans des plans parallèles. La deuxième zone présente des flancs qui s'étendent perpendiculairement auxdits plans.
- Selon un mode de réalisation, au moins une parmi la première et la deuxième électrode s'étend principalement dans un plan. La deuxième zone est délimitée par des flancs qui s'étendent perpendiculairement audit plan. Ainsi, la surface de la deuxième zone, prise dans un plan parallèle à celui des électrodes, est constante sur l'épaisseur du dispositif.
- au moins une électrode parmi les première et deuxième électrodes est située au contact de la deuxième zone au moins dans la deuxième zone.
- L'une au moins parmi les première et deuxième électrodes est une électrode non-inerte apte à réagir avec la couche d'oxyde de sorte à créer des lacunes d'oxygène ou défauts dans ladite couche d'oxyde lorsqu'une tension est appliquée au dispositif.
- la couche d'oxyde est formée à base d'oxyde métallique ou de nitrure métallique, ou d'un empilement bi-couche. Par exemple, comme cité dans le brevet Herner et al., U.S. patent application Ser. No. 11/395,995, "Nonvolatile Memory Cell Comprising a Diode and a Resistance-Switching Material," filed Mar. 31, 2006, NiₓO_{y}, NbₓO_{y}, TiₓO_{y}, HfₓO_{y}, AlₓO_{y}, MgₓO_{y}, CoₓO_{y}, CrₓO_{y}, VₓO_{y}, ZnₓO_{y}, ZrₓO_{y}, BₓN_{y}, and AlₓN_{y} montrent une variation de résistance en fonction des conditions de programmation. On peut avoir également Zr02, TaOx, HfxAlyOz.
- la couche d'oxyde est au contact direct d'au moins une électrode parmi les première et deuxième électrodes au niveau de la deuxième zone et au niveau de la première zone.
- la couche d'oxyde est au contact direct d'au moins une électrode parmi les première et deuxième électrodes au niveau de la deuxième zone et comprend au moins une couche intermédiaire entre la couche d'oxyde et l'au moins une électrode parmi les première et deuxième électrodes au niveau de la première zone.
- la première zone et la deuxième zone sont contiguës. Elles ne sont pas séparées par une couche ou un espace intermédiaire.
   Ladite au moins une couche intermédiaire est une couche à base de nitrure.
- la distance d1 est comprise entre 5 nanomètres et 20 nanomètres et de préférence entre 5 nanomètres et 15 nanomètres. Ce sont des cas particulièrement avantageux avec l'exemple de l'empilement TiN/Hf02/Ti(10nm)/TiN.
- la distance d2 est comprise entre 2 nanomètres et 15 nanomètres et de préférence entre 2 nanomètres et 10 nanomètres. Ce sont des cas particulièrement avantageux avec l'exemple de l'empilement TiN/Hf02/Ti(10nm)/TiN.
- la distance d1 est comprise entre 5 nanomètres et 15 nanomètres et la distance d2 est comprise entre 2 nanomètres et 10 nanomètres. Ce sont des cas particulièrement avantageux avec l'exemple de l'empilement TiN/Hf02/Ti(10nm)/TiN.
- la surface d'au moins une électrode parmi les première et deuxième électrodes située au regard de la première zone est comprise entre 0,01 et 10 micromètres carrés. Cela reste particulièrement avantageux avec un cas particulier basé sur les données électriques réalisées à partir d'un empilement TiN/Hf02/Ti(10nm)/TiN.
- la surface d'au moins une électrode parmi les première et deuxième électrodes située au regard de la deuxième zone est comprise entre 0,0001 et 0,25 micromètres carrés. Cela reste particulièrement avantageux avec un cas particulier basé sur les données électriques réalisées à partir d'un empilement TiN/Hf02/Ti(10nm)/TiN.
- la distance d1 est comprise entre 5 nanomètres et 15 nanomètres, la distance d2 est comprise entre 2 nanomètres et 10 nanomètres. La surface d'au moins une électrode parmi les première et deuxième électrodes située au regard de la première zone est comprise entre 0,01 et 10 micromètres carré. La surface de l'au moins une électrode parmi les première et deuxième électrodes située au regard de la deuxième zone est comprise entre 0,0001 et 0,25 micromètres carré.
- On réalise une étape préalable de localisation de la formation d'au moins un filament conducteur dans la deuxième zone lorsqu'une tension est appliquée au dispositif en fonction des première et deuxième distances relatives d1, d2 et en fonction de la surface d'au moins une électrode parmi les première et deuxième électrodes située au regard de la première zone et en fonction de la surface de l'au moins une électrode parmi les première et deuxième électrodes située au regard de la deuxième zone. Plus précisément, on prend en compte le ratio entre une première surface qui est la surface d'au moins une électrode parmi les première et deuxième électrodes située au regard de la première zone et une deuxième surface de cette électrode située au regard de la deuxième zone.
- l'étape de localisation comprend la détermination d'un ratio entre la deuxième distance d2 et la première distance d1, compris entre 0,2 et 0,7 ou entre 0,5 et 0,85, de manière à ce que le filament conducteur se forme dans la deuxième zone.
- l'étape de localisation comprend la détermination d'un ratio entre d'une part la surface par laquelle au moins une électrode parmi les première et deuxième électrodes est située au regard de la première zone et d'autre part la surface par laquelle cette électrode est située au regard de la deuxième zone, le ratio étant compris entre 0,0001 et 0,5.
- la formation de la deuxième zone est réalisée par un amincissement partiel de la couche d'oxyde.
- Selon un mode de réalisation du procédé, l'étape de formation de la couche d'oxyde réalisée de sorte à ce que la couche d'oxyde présente une première zone et une deuxième zone d'une couche d'oxyde comprend les étapes suivantes :
   - la formation, par exemple par dépôt ou par report, d'une couche d'oxyde sur une électrode parmi les première et deuxième électrodes;
   - une étape d'amincissement de la couche d'oxyde de manière à former la deuxième zone ;
le procédé comprenant ensuite le dépôt de l'autre électrode parmi les première et deuxième électrodes sur la première couche d'oxyde.
Avantageusement l'épaisseur de la couche d'oxyde, après l'étape d'amincissement et au niveau de la zone, présente une épaisseur égale à la distance minimale d2. Ce procédé a pour avantage d'être particulièrement simple et fiable.
- Selon un mode de réalisation du procédé l'étape de formation de la couche d'oxyde réalisée de sorte à ce que la couche d'oxyde présente une première zone et une deuxième zone d'une couche d'oxyde comprend les étapes suivantes :
   - la formation, par exemple par dépôt ou par report, d'une première couche d'oxyde sur une électrode parmi les première et deuxième électrodes;
   - le retrait de toute l'épaisseur de la première couche d'oxyde uniquement au niveau de la deuxième zone de manière à mettre à nu ladite électrode parmi les première et deuxième électrodes au niveau de la deuxième zone;
   - la formation, de préférence par dépôt, d'une deuxième couche d'oxyde sur la première couche d'oxyde et sur ladite électrode parmi les première et deuxième électrodes mise à nu au niveau de la deuxième zone;
   le procédé comprenant ensuite le dépôt de l'autre électrode parmi les première et deuxième électrodes.

De préférence, l'épaisseur de la deuxième couche telle que déposée est égale à la distance minimale d2.

Ainsi, la formation de la deuxième zone est réalisée de sorte à ce que la distance minimale d2 séparant les première et deuxième électrodes au niveau de la deuxième zone soit égale à l'épaisseur de la deuxième couche d'oxyde. La distance d2 est donc uniquement contrôlée par l'épaisseur du dépôt de la deuxième couche. Cette épaisseur peut ainsi être contrôlée très précisément.
Par ailleurs, les deux surfaces de la couche d'oxyde au niveau de la deuxième couche est intègre. En particulier, la face au regard de l'autre électrode n'a pas été endommagée par une gravure. Les performances du dispositif en sont améliorées.

Le retrait de la première couche au niveau de la deuxième zone est par exemple effectué par lithographie, par faisceau d'électrons par exemple.

Toutes ces gammes d'épaisseurs, de surfaces, de ratios d'épaisseurs, de ratios de surfaces, sont particulièrement avantageux pour un exemple très particulier de réalisation, non limitatif de l'invention, comprenant un empilement de couches de type TiN/Hf02/Ti(10nm)/TiN. D'autres exemples d'empilement de couches sont possibles.

Il est précisé que dans le cadre de la présente invention, le terme « sur » ne signifie pas obligatoirement « au contact de ». Ainsi, par exemple, le dépôt d'une couche sur une autre couche, ne signifie pas obligatoirement que les deux couches sont directement au contact l'une de l'autre mais cela signifie que l'une des couches recouvre au moins partiellement l'autre en étant soit directement à son contact, soit en étant séparée d'elle par un film, encore une autre couche ou un autre élément.

L'expression 'la zone de l'élément A est située « au droit » ou « au regard» de l'élément B' signifie que la zone de l'élément A et l'élément B sont superposés, en contact direct ou non, suivant une direction perpendiculaire au plan principal dans lequel s'étend la couche d'oxyde. Cette direction correspond à la verticale sur les figures 3A à 4D notamment.

La **figure 2A** illustre un dispositif mémoire comprenant une couche d'oxyde 300 disposée entre une première électrode 100 et une deuxième électrode 200.
Lors d'étapes de programmation, c'est-à-dire lorsqu'une tension et un courant suffisants sont appliqués au dispositif, avec une limitation en courant traversant le dispositif, inférieure, par exemple, à quelques milliampères, des filaments conducteurs 500 peuvent sélectivement être crées et être rompus entre les électrodes 100, 200 au travers de la couche d'oxyde 300.

Le dispositif comprenant une couche d'oxyde 300 disposée entre une première électrode 100 et une deuxième électrode 200 est configuré de sorte à former des défauts 600 (par exemple des atomes métalliques ou des lacunes 600 d'oxygène) dans la couche d'oxyde 300. A titre préféré, une au moins des électrodes 100, 200 est apte à réagir avec la couche d'oxyde 300. Dans la description qui suit, cette électrode 100, 200 sera désignée comme électrode non-inerte ou électrode active. Selon un mode de réalisation préféré mais non limitatif de l'invention, le dispositif mémoire selon la présente invention comprend au moins une électrode non inerte, l'autre électrode étant par défaut, qualifiée d'électrode inerte, c'est-à-dire qui ne réagit pas avec la couche d'oxyde 300.
L'invention s'étend en effet au cas où les deux électrodes 100, 200 sont non-inertes ou encore au cas où les deux électrodes 100, 200 sont inertes.

Il apparaît, dans l'exemple illustré en figure 2A, que les filaments conducteurs 500 se forment au travers de la zone de la couche d'oxyde 300 pourvue de défauts 600. Lorsque la surface de contact 250 entre l'au moins une électrode 200, préférentiellement non-inerte, et la couche d'oxyde 300, est importante, le nombre de chemins parasites de filaments conducteurs 500 qui peuvent être crées lors d'étapes de programmation est élevé, pouvant générer, dans le temps, une instabilité importante des dispositifs à mémoire résistive.

La **figure 2B** illustre un dispositif mémoire obtenu dans le cadre du développement de la présente invention, selon un mode de réalisation particulier. Ce dispositif comprend une première électrode 100, de préférence mais non limitativement, choisie comme étant inerte et une deuxième électrode 200, et une couche d'oxyde 300 à partir de ladite deuxième électrode 200, de préférence mais non limitativement choisie non-inerte. Ce dispositif est apte à créer des défauts 600 dans la couche d'oxyde 300.
Dans ce mode de réalisation, la surface de la deuxième électrode 200 a été réduite de sorte à réduire la surface de contact 250 entre ladite deuxième électrode 200 et la couche d'oxyde 300.
Avantageusement, en diminuant la surface de contact 250 entre au moins une électrode 100, 200 et la couche d'oxyde 300, le nombre de chemins parasites est moindre. Les filaments conducteurs 500, possiblement formés, sont confinés suite à la diminution de la surface de contact 250 entre la deuxième électrode 200 et la couche d'oxyde 300. La réduction du nombre de chemins parasites peut avantageusement permettre de réduire l'instabilité dans le temps des dispositifs ou encore réduire la variabilité des performances de tels dispositifs, suite au confinement des filaments conducteurs 500 dans une zone restreinte.

La diminution de la surface de contact 150, 250 peut se faire à partir de la première électrode 100 et/ou à partir de la deuxième électrode 200. Selon un exemple alternatif où la réduction de la surface de contact 150 s'effectue à partir de la première électrode 100, alors la première électrode 100 sera avantageusement mais non limitativement choisie de sorte à être non-inerte c'est-à-dire apte à réagir avec la couche d'oxyde 300 et la deuxième électrode 200 sera choisie de sorte à être inerte.

Néanmoins, un inconvénient d'un tel dispositif mémoire réside dans les contraintes de réalisation de l'électrode 100, 200 dont la surface est réduite. Cela requiert en outre des étapes de lithographie à l'échelle nanométrique.
Former des électrodes 100, 200 dont la surface est réduite (par exemple, de l'ordre du micromètre carré (µm²), voire de la centaine de nanomètres carrés (nm²) nécessite notamment une étape de dépôt d'une couche métallique représentant ladite électrode 100, 200 sur la couche d'oxyde 300, suivie d'une étape de lithographie par masquage, une étape de gravure de ladite électrode 100, 200 ne laissant en place qu'une partie de ladite électrode 100, 200 non exposée lors de l'étape de masquage. La partie restante de l'électrode 100, 200 ne s'étend que sur une faible surface. Ainsi, un inconvénient additionnel est lié à la difficulté d'une reprise de contact à réaliser à partir de ladite partie restante de l'électrode 200 de dimension surfacique réduite (de l'ordre du micromètre carré).

Le dispositif mémoire selon la présente invention comporte des éléments de dimensions microniques et/ou nanométriques. La description qui suit a pour but préférentiel de présenter un dispositif mémoire et son procédé de réalisation en référence aux figures 3A à 7C.

La **figure 3A** illustre un dispositif mémoire selon un premier mode de réalisation comprenant une couche d'oxyde 300 disposée entre une première électrode 100 et une deuxième électrode 200.
Selon un mode de réalisation préféré mais non limitatif de l'invention, la première électrode 100 est choisie de sorte à être inerte, c'est-à-dire configurée pour ne pas réagir avec la couche d'oxyde 300. Préférentiellement, la première électrode 100 peut être formée en un matériau, par exemple, à base de Platine, de nitrure de titane (TiN), ou de nitrure de tantale (TaN). Avantageusement mais de manière non limitative, la deuxième électrode 200 est choisie de sorte à être non-inerte, c'est-à-dire configurée pour réagir avec la couche d'oxyde 300, en créant des lacunes d'oxygène ou défauts 600 dans ladite couche d'oxyde 300. Préférentiellement, la deuxième électrode 200 peut être formée en un matériau à base de titane (Ti), tantale (Ta), hafnium (Hf), de zirconium (Zr), par exemple. L'invention s'étend également au cas où les deux électrodes 100, 200 sont non-inertes ou encore au cas où les deux électrodes 100, 200 sont inertes.

La couche d'oxyde 300 est de préférence choisie parmi une oxyde métallique, par exemple à base d'oxyde d'hafnium (HfO₂), d'oxyde de titane (TiO₂), d'oxyde de tantale (Ta₂O₅), d'oxyde de Nickel (NiO), d'oxyde de Zinc (ZnO) ou de bicouches (par exemple de type Al2O3/Hf02).

Un moyen d'obtenir le confinement du filament conducteur, sans avoir à réduire considérablement la surface d'au moins une électrode 100, 200 du dispositif mémoire, ce qui est difficile à réaliser et coûteux, est de venir affiner localement, de façon contrôlée, l'épaisseur de la couche d'oxyde 300 et plus précisément de réduire la distance entre les première et deuxième électrodes 100, 200.

Le dispositif mémoire illustré en figure 3A comprend au moins une première zone 301 où les première et deuxième électrodes 100, 200 sont séparées d'une première distance d1. Selon un mode de réalisation non limitatif, cette première distance d1 correspond à l'épaisseur de la couche d'oxyde 300 déposée initialement sur l'une des électrodes 100, 200. La distance d1, comme la distance d2 décrite par la suite, sont mesurées selon une direction perpendiculaire au plan principal dans lequel s'étend la couche d'oxyde 300. Sur les figures, cette direction est verticale. La distance d1 correspond à la distance la plus courte séparant les première et deuxième électrodes 100, 200 dans la première zone 301. La distance d2 correspond à la distance la plus courte séparant les première et deuxième électrodes 100, 200 dans la deuxième zone 302. En tout point de la première zone 301, la distance séparant les première et deuxième électrodes 100, 200 est inférieure ou égale à la distance séparant les première et deuxième électrodes 100, 200 dans la deuxième zone 302. La distance séparant les première et deuxième électrodes 100, 200 peut être égale à la distance séparant les première et deuxième électrodes 100, 200 au niveau de la jonction entre les première 301 et deuxième 302 zones si cette jonction est continue. En dehors de la jonction entre les première 301 et deuxième 302 zones, la distance séparant les première et deuxième électrodes 100, 200 est inférieure à la distance séparant les première et deuxième électrodes 100, 200.
De manière particulièrement avantageuse, le dispositif mémoire comprend une deuxième zone 302 où les première et deuxième électrodes 100, 200 sont séparées d'une deuxième distance d2. Avantageusement, la deuxième distance d2 est inférieure à la première distance d1. Avantageusement, la première zone 301 entoure la deuxième zone 302. La deuxième zone 302 est ainsi située au sein d'un volume entièrement occupé par la première zone 301. Selon un autre mode de réalisation, la première zone 301 est située de part et d'autre de la deuxième zone 302. Selon ce mode de réalisation, la deuxième zone 302 forme par exemple un relief s'étendant principalement selon une direction longitudinale et la première zone 301 forme par exemple deux reliefs, chaque relief s'étendant selon la direction longitudinale et d'un côté du relief de la deuxième zone 302.

Dans la deuxième zone 302 de la couche d'oxyde 300, c'est-à-dire dans la portion où les électrodes 100, 200 sont à une distance d2 réduite l'une de l'autre, le champ électrique traversant la deuxième zone 302 sera plus important que celui traversant la première zone 301.

La deuxième électrode 200, de préférence mais non limitativement choisie non-inerte, génère des lacunes d'oxygène ou défauts 600 dans la couche d'oxyde 300. Dans la deuxième zone 302 où les première et deuxième électrodes 100, 200 sont rapprochées, la couche d'oxyde 300 amincie par rapport à la première zone 301, favorisant ainsi la création de filaments conducteurs 500 au niveau de ladite deuxième zone 302 de la couche d'oxyde 300.

Grâce à cette délimitation prédéfinie d'une première zone 301 et d'une deuxième zone 302 dans la couche d'oxyde 300, il est possible de confiner les filaments conducteurs 500 dans une certaine zone (soit la deuxième zone 302) de ladite couche d'oxyde 300 et de réduire, la dispersion desdits filaments conducteurs 500 qui peut être responsable de la variabilité des performances cycles après cycles.

La **figure 3B** illustre un dispositif mémoire selon un deuxième mode de réalisation comprenant une couche d'oxyde 300 disposée entre une première électrode 100 et une deuxième électrode 200. Le dispositif mémoire comprend une première zone 301 où les première et deuxième électrodes 100, 200 sont séparées d'une distance d1. Dans ce mode de réalisation, la distance d1 correspond à l'épaisseur de la couche d'oxyde 300 déposée initialement sur l'une des électrodes 100, 200 à laquelle s'ajoute l'épaisseur d'une couche intermédiaire 700, de préférence isolante électriquement. Préférentiellement, la couche intermédiaire 700 est formée de sorte à ne recouvrir que la première zone 301 de la couche d'oxyde 300. La couche intermédiaire 700 comprend une ouverture permettant de venir amincir par gravure la couche d'oxyde 300, puis, à la deuxième électrode 200, d'accéder à la deuxième zone 302 de la couche d'oxyde 300. Préférentiellement, la couche intermédiaire 700 comprend un matériau isolant par exemple à base d'oxyde de silicium (SiO2), de nitrure de silicium (SiN), de carbure de silicium (SiC) L'épaisseur de la couche intermédiaire 700 est comprise entre 5 nm et 100 nm, de préférence de l'ordre de 20 nm. Cette épaisseur dépend de l'épaisseur minimale que l'on peut déposer (fonction du matériau). Dans le cas où l'on veut minimiser les dimensions latérales de la deuxième zone 302, il est préférable de ne pas avoir un rapport d'aspect entre la hauteur (correspondant à l'épaisseur de matériau 700 restant après gravure) et la largeur de la zone « ouverte » surplombant la zone d2 trop importante, ceci pour avoir un bon remplissage avec le matériau 200.

La deuxième distance d2 correspond, quant à elle, à l'épaisseur de la couche d'oxyde 300 déposée initialement sur l'une des électrodes 100, 200 à laquelle est soustraite la profondeur de la gravure partielle de la couche d'oxyde 300 réalisée par l'ouverture de la couche intermédiaire 700. Ainsi, la deuxième distance d2 est inférieure à la première distance d1. Ceci génère un champ électrique dans la deuxième zone 302 de la couche d'oxyde 300 supérieur à celui dans la première zone 301.

Ce deuxième mode de réalisation permet avantageusement de confiner le filament conducteur 500 dans la zone où le champ électrique sera plus important, c'est-à-dire dans la deuxième zone 302 de la couche d'oxyde 300.

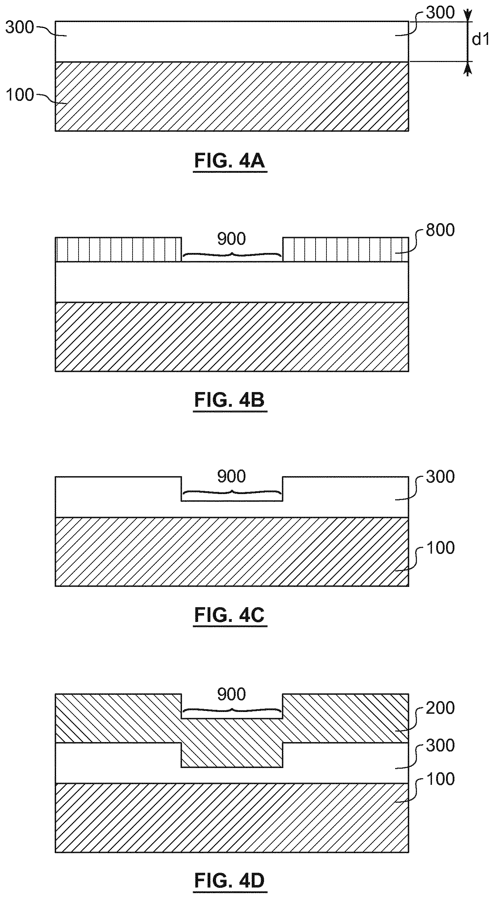

Les **figures 4A** à **4D** illustrent les étapes de réalisation du dispositif mémoire présenté sur la figure 3A selon la présente invention.
Une première étape (figure 4A) consiste en la formation d'une première électrode 100, suivie de la formation d'une couche d'oxyde 300 comprenant une première zone 301 d'une distance d1, correspondant à l'épaisseur de la couche d'oxyde 300 déposée.
Il s'ensuit une étape de lithographie (figure 4B), de préférence une lithographie par faisceau d'électrons ou lithographie électronique, destinée à définir des motifs 900 dans la couche d'oxyde 300 ; lesdits motifs pouvant avoir une surface de l'ordre du micromètre carré, et avantageusement de l'ordre de la centaine de nanomètres carrés. Par rapport à la photolithographie, l'avantage de cette technique de lithographie par faisceau d'électrons est qu'elle permet de repousser les limites de la lithographie optique et de dessiner des motifs 900 avec une résolution pouvant aller jusqu'à des dimensions de l'ordre des décananomètres. Afin de réaliser les motifs de faible dimension surfacique, une couche de résine négative 800 est préférablement utilisée lors de la lithographie électronique. On entend par résine « négative », un type de résine photosensible pour laquelle la partie exposée à la lumière devient insoluble au révélateur et où la partie de résine photosensible, non exposée, reste soluble.
Selon d'autres modes de réalisation, le motif 900 sera formé par une technique de photolithographie optique ou extrême de type ultra-violet (UV) ou par nano-impression. Après l'étape de lithographie, on réalise une étape de gravure partielle (soit un amincissement) de la couche d'oxyde 300 (figure 4C) afin de former au moins un motif 900 dans la couche d'oxyde 300, par transfert du motif 900 formé préalablement dans la couche de résine 800. On entend par gravure partielle, une gravure configurée de sorte à retirer une partie seulement de l'épaisseur de la couche gravée. La couche de résine 800 préalablement formée va permettre de protéger les zones de la couche d'oxyde 300 qui n'auront pas à être gravées ou qui devront être gravées dans une moindre mesure. La gravure de la couche d'oxyde 300 est préférentiellement anisotrope. La gravure est, par exemple, réalisée par gravure au plasma ou par gravure humide. La couche de résine 800 restante est ensuite retirée.
On réalise ensuite la deuxième électrode 200 par dépôt d'une couche, de préférence métallique, sur toute la surface de la couche d'oxyde 300. De préférence, le dépôt est conforme.
Avantageusement, pour ce type de dispositif mémoire, la reprise de contact sur chacune des première et deuxième électrodes 100, 200 est facilitée puisque les électrodes 100, 200 conservent de larges surfaces.

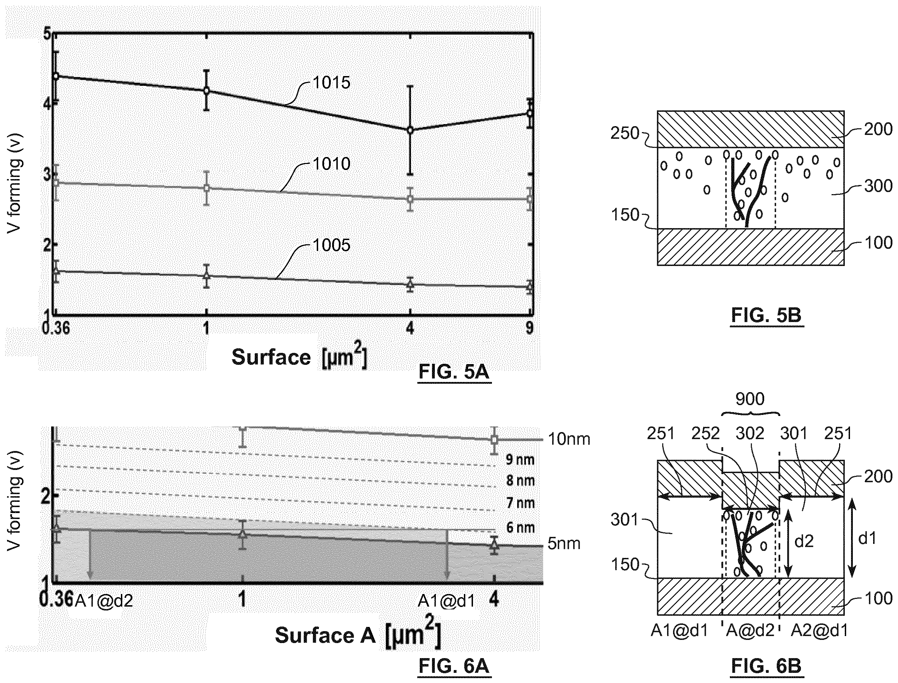

La **figure 5A** illustre un graphe représentant la tension de forming pour différentes épaisseurs de la couche d'oxyde 300 en fonction de la surface des dispositifs. On entend par tension de « forming », désignée par la suite V_{FORMING}, la différence de potentiel qu'il faut appliquer entre les deux électrodes 100, 200 pour provoquer une rupture (en anglais « breakdown ») de la capacité d'isolation de la couche d'oxyde 300, assimilée ainsi à une condition de faible résistance du dispositif mémoire. Cette rupture correspond à la formation d'un chemin ou d'un filament conducteur au sein de la couche d'oxyde 300 et qui relie les deux électrodes 100, 200. Plus généralement, V_{FORMING} est l'amplitude minimale de tension qu'il faut appliquer aux bornes de la cellule pour la rendre conductrice ou pour la rendre significativement plus conductrice que dans l'état hautement résistif.

La tension V_{FORMING} est la tension minimale à appliquer au dispositif pour passer d'un premier état résistif (« HRS » acronyme en anglais pour « High Resistive State ») à un deuxième état résistif (« LRS » acronyme en anglais pour « Low Resistive State »). Le dispositif dans l'état LRS présente une résistance inférieure, de préférence deux fois, et de préférence dix fois, et de préférence cent fois, à la résistance du dispositif dans l'état HRS.

Dans un dispositif mémoire, il est avantageux d'obtenir une faible tension de forming V_{FORMING}.

La **figure 5B** est une illustration du dispositif mémoire utilisé pour réaliser le graphe de la figure 5A. Le dispositif mémoire utilisé comprend une couche d'oxyde 300 disposée entre une première électrode 100 et une deuxième électrode 200. Selon cet exemple, on choisit une couche d'oxyde 300 à base d'oxyde d'hafnium (HfO₂).
Le graphe de la figure 5A compare les tensions V_{FORMING} obtenues relativement aux épaisseurs prédéfinies de la couche d'oxyde 300.
La courbe 1005 représente un dispositif mémoire dont la couche d'oxyde 300 est de l'ordre de 5 nanomètres (nm). La courbe 1010 représente un dispositif mémoire dont la couche d'oxyde 300 est de l'ordre de 10 nanomètres. La courbe 1015 représente un dispositif mémoire dont la couche d'oxyde 300 est de l'ordre de 15 nanomètres. Il apparaît clairement que la tension V_{FORMING} augmente avec l'épaisseur de la couche d'oxyde 300.
Ainsi, plus la distance séparant la première électrode 100 et la deuxième électrode 200 est faible (par exemple 5 nm, courbe 1005), plus la tension V_{FORMING} est faible. Il semble donc préférable de réduire la distance séparant la première électrode 100 de la deuxième électrode 200, afin d'obtenir une faible tension V_{FORMING}.
Par ailleurs, tel que cela est illustré en figure 5A, il est établi que, plus la surface du dispositif mémoire (on entend ici la dimension surfacique de la deuxième électrode 200) est grande, plus la tension V_{FORMING} est faible (voir l'évolution des courbes 1005, 1010, 1015 en fonction de la surface des dispositifs).
Afin d'obtenir une tension V_{FORMING} faible, un compromis serait de réduire la distance entre les électrodes 100, 200, tout en augmentant la surface de contact entre la deuxième électrode 200 et la couche d'oxyde 300.

La **figure 6A** est un agrandissement de la figure 5A, illustrant une extrapolation des résultats précédemment obtenus. La figure 6B est une illustration du dispositif mémoire utilisé pour expliquer le graphe de la figure 6A. Le dispositif mémoire de la figure 6B comprend une couche d'oxyde 300 disposée entre une première électrode 100 et une deuxième électrode 200. Dans une première zone 301, les électrodes 100, 200 sont séparées d'une distance d1. Dans une deuxième zone 302, les électrodes 100, 200 sont séparées d'une distance d2. Avantageusement, la première zone 301 entoure la deuxième zone 302. Selon un autre mode de réalisation, la première zone 301 est située de part et d'autre de la deuxième zone 302. Préférentiellement, la distance d2 est inférieure à la distance d1.

La tension V_{FORMING} globale du dispositif illustré en fig. 6B est celle obtenue par la tension la plus faible entre :
- la tension V_{FORMING} associée à la première zone 301 où les électrodes 100, 200 sont séparées selon la distance d1 (correspondant aux surfaces A1 et A2 de contact 251 entre la première zone 301 de la couche d'oxyde 300 et la deuxième électrode 200 ; lesdites surfaces étant désignées A1@d1, A2@d1).
- la tension V_{FORMING} associée à la deuxième zone 302 où les électrodes 100, 200 sont séparées selon la distance d2 (correspondant à la surface A de contact 252 entre la deuxième zone 302 de la couche d'oxyde 300 et la deuxième électrode 200 ; ladite surface étant désignée A@d2).

La figure 6A illustre les résultats d'une étape de localisation définissant un ratio optimisé des surfaces de contact 251, 252 entre, d'une part, la deuxième électrode 200 et la première zone 301 et, d'autre part, la deuxième électrode 200 et la deuxième zone 302 ; ce ratio permettant de favoriser la formation du filament conducteur 500, à l'intérieur de la deuxième zone 302, plutôt qu'au niveau de la première zone 301.

Pour ce faire, on réalise, lors d'une première étape, une mesure de la tension V_{FORMING} pour différentes surfaces de contact et différentes épaisseurs de la couche d'oxyde 300 tel qu'illustré en figure 5A. Il est alors possible d'effectuer une extrapolation afin d'obtenir un comportement en fonction de différentes épaisseurs intermédiaires de la couche d'oxyde 300 entre 5 nm et 10 nm, par exemple pour des épaisseurs de la couche d'oxyde 300 de l'ordre de 6 nm, 7 nm, 8 nm, 9 nm.

Selon un mode de réalisation particulier, on choisit une tension V_{FORMING} commune entre deux épaisseurs, par exemple une tension V_{FORMING} de l'ordre de 1.8V pour des épaisseurs (plus précisément pour des distances séparant les électrodes 100, 200) par exemple de 5 nm pour la distance d2 et de 6 nm pour la distance d1.

Afin d'assurer une tension V_{FORMING} inférieure dans la deuxième zone 302, c'est-à-dire dans la zone choisie pour confiner les filaments conducteurs 500, que dans la première zone 301, on détermine une surface minimale de contact A@d2. Pour une même valeur de la deuxième distance d2, on choisit une surface de contact (c'est-à-dire la surface du motif 900 formé dans la couche d'oxyde 300) entre la deuxième électrode 200 et la couche d'oxyde 300 supérieure à la surface minimale de contact A@d2, de sorte à ce que la tension V_{FORMING} pour ladite surface soit forcément plus faible que celle de la surface minimale. Par exemple, sur l'exemple illustré en Fig. 6A, pour la deuxième zone 302 présentant une distance d2 (égale à 5 nm par exemple), on choisit une surface de contact supérieure ou égale à 0,4 µm². De la même manière, on choisit une surface A@d1 en dessous de laquelle la tension V_{FORMING} sera forcément supérieure à celle déduite pour la deuxième zone 302 de la couche d'oxyde 300. Par exemple, sur l'exemple illustré en Fig. 6A, pour la première zone 301 présentant une distance d1 (égale à 6 nm par exemple), on choisit une surface de contact inférieure ou égale à 3,5 µm².

Ainsi, on sera assuré que pour une tension de 1.8 V appliquée aux bornes des électrodes 100, 200, les filaments conducteurs 500 sont confinés dans la deuxième zone 302.

Pour réduire au maximum la variabilité, on cherchera à utiliser la surface la plus petite possible pour A@d2, dans la deuxième zone 302.

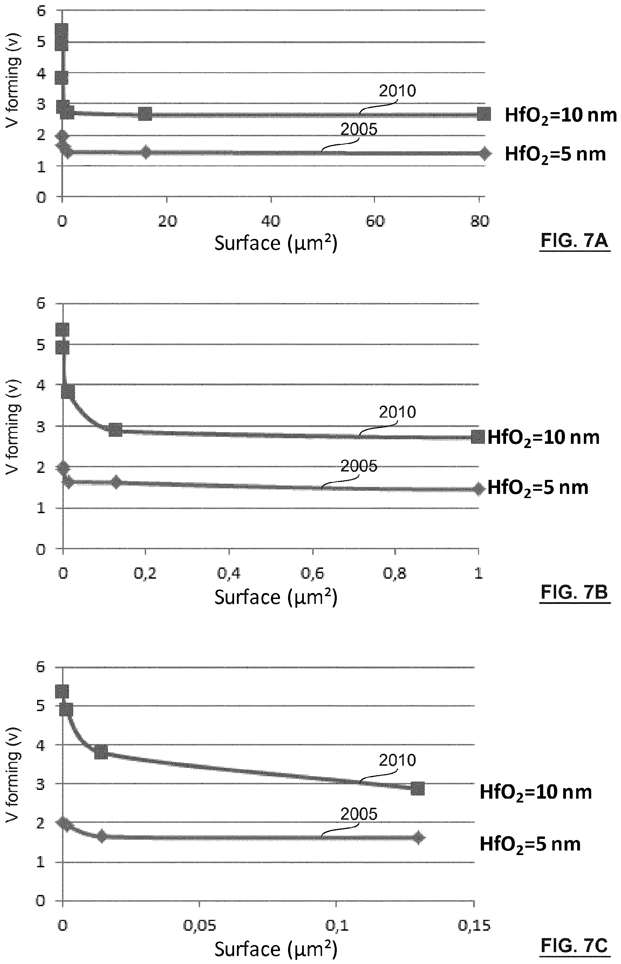

Les **figures 7A** à **7C** illustrent des graphes représentant la tension V_{FORMING} en fonction de la surface de contact du dispositif mémoire, pour différentes épaisseurs de la couche d'oxyde 300. La figure 7A permet d'estimer une tension V_{FORMING} en fonction de la surface de contact, pour des surfaces allant de 0,0001 µm² à 80 µm². Elle est issue de données expérimentales obtenues pour des surfaces allant de 0.36 µm² à 96 µm² sur un empilement de couches comprenant une première électrode 100 par exemple à base de nitrure de titane (TiN), une couche d'oxyde 300 par exemple à base d'oxyde d'hafnium (HfO₂) et une deuxième électrode 200 par exemple à base de titane/nitrure de titane. Pour des surfaces plus faibles, les tensions V_{FORMING} sont extraites à partir d'expériences réalisées sur un empilement de couches comprenant, selon un exemple non limitatif de l'invention, une première électrode 100 à base de TiN, une couche d'oxyde 300 à base de HfO₂, une deuxième électrode à base de Hf/TiN, pour différentes épaisseurs de la couche d'oxyde 300. La courbe 2005 représente un dispositif mémoire dont la couche d'oxyde 300 est de l'ordre de 5 nanomètres. La courbe 2010 représente un dispositif mémoire dont la couche d'oxyde 300 est de l'ordre de 10 nanomètres.

Les graphes des figures 7A à 7C font clairement ressortir un comportement de la tension V_{FORMING} de type exponentiel notamment pour des surfaces inférieures à 1 µm².
D'après les figures 7B et 7C, il apparaît que pour des surfaces très petites (inférieures à 0,1 µm²), la tension V_{FORMING} n'augmente plus de façon linéaire, mais davantage de façon exponentielle.
Selon un exemple de réalisation, pour le cas d'une couche d'oxyde 300, par exemple à base de HfO₂, d'une épaisseur de l'ordre de 10 nm, pour une surface de 40 nm x 40 nm, soit de 0,0016 µm², la tension V_{FORMING} est comprise entre 4.3 V et 6 V, alors qu'elle est comprise entre 2 V et 3.8 V pour une surface de 120 nm x 120 nm, soit d'environ 0,014 µm² (9 fois plus élevée).

Pour la deuxième zone 302 de la couche d'oxyde 300, la surface de contact est préférentiellement choisie inférieure à 0,01 µm² (soit 100 nm x 100 nm). Pour la première zone 301, les surfaces sont par exemple réalisées avec des techniques de lithographie optique avec des dimensions non agressives, typiquement comprises entre 0,04 µm² et quelques micromètres carrés.
Comme cela est illustré sur les figures 7B et 7C, pour une couche d'oxyde 300, par exemple à base de HfO₂, d'une épaisseur de l'ordre de 10 nm et des surfaces de l'ordre de 0,04 µm², la tension V_{FORMING} requise est supérieure à 3V et de préférence de l'ordre de 3,5V. Pour une couche d'oxyde 300 dont la deuxième zone 302 possède une épaisseur de HfO₂ de 5 nm et une surface inférieure à 0,01 µm², la tension V_{FORMING} requise est de l'ordre de 2 V.

Cependant, l'instabilité dans le temps des états résistifs observée dans le dispositif mémoire étant assez importante, il convient d'en tenir compte pour le dimensionnement de la deuxième zone 302 de la couche d'oxyde 300.
Ainsi, selon un exemple, la tension V_{FORMING} maximum obtenue pour une épaisseur de HfO₂ de 5 nm est de l'ordre de 2,55 V pour une surface de 0,0001 µm² (10nm*10nm). La tension V_{FORMING} minimale obtenue pour une épaisseur de HfO₂ de 10 nm et pour une surface de 1 µm² est de l'ordre de 2,2 V. Dans cette configuration, si l'on choisit une distance d1 de l'ordre de 10 nm pour la première zone 301 avec une surface de contact de 1 µm² et une distance d2 de l'ordre de 5 nm pour la deuxième zone 302 avec une surface de contact de 0,0001 µm², les tensions V_{FORMING} dans chacune des première et deuxième zones 301, 302 étant relativement proches, il existe un risque de former un filament conducteur 500 dans la première zone 301.

Afin d'éviter au mieux ce problème, il existe deux possibilités envisagées dans le cadre du développement de la présente invention. Une première possibilité consiste à conserver le même rapport (ou ratio) d'épaisseurs d2/d1 (ou distances relatives entre les électrodes 100, 200) et de veiller à travailler avec des surfaces de contact qui permettent d'avoir une tension V_{FORMING} dans la première zone 301, supérieure à la tension V_{FORMING} maximum, à laquelle on ajoute par exemple une valeur de tension de 1 V, dans la deuxième zone 302. Selon un exemple de réalisation, une tension V_{FORMING} dans la première zone 301 est choisie supérieure à 3,5 V environ, ce qui induit de restreindre le choix des surfaces de contact à une surface inférieure ou égale à 0,04 µm², soit environ inférieure à 200 nm x 200 nm. Dans ce mode de configuration, il n'existe que peu de choix de surfaces de contact pour la première zone 301.

Une deuxième possibilité est de travailler avec une distance d1 entre les électrodes 100, 200 (ou une épaisseur de la couche d'oxyde 300) dans la première zone 301 notablement plus importante que la distance d2 dans la deuxième zone 302, surtout si l'on souhaite former des surfaces de contact plus larges. Ainsi, selon un exemple de réalisation, avec une épaisseur de la couche d'oxyde 300, par exemple de HfO₂, de 15 nm, la tension V_{FORMING} est en moyenne toujours supérieure à 3,8V, même en intégrant une barre d'erreurs (représentant la variabilité sur la tension V_{FORMING}) de 1V. La tension V_{FORMING} minimale obtenue serait de 3,3V, ce qui permet de garantir qu'on ne formerait pas le filament conducteur 500 dans la première zone 301, mais dans la deuxième zone 302 où la tension V_{FORMING} sera moins élevée. Dans ce mode de configuration, il existe un large choix de surfaces de contact.

Selon un exemple de réalisation, on trace les courbes de tension V_{FORMING} en fonction des différentes épaisseurs d'oxyde. On fixe le couple (d1, d2).

Selon un exemple de réalisation préféré, on définit la distance d1 correspondant à une première tension V_{FORMING} minimale pour une surface A1 supérieure ou égale à 5 µm² et la distance d2 correspondant à une deuxième tension V_{FORMING} maximale (pour une surface A2 supérieure ou égale à 100 nm²). La surface A1 est la limite inférieure de la surface au-delà de laquelle la tension de forming V_{FORMING} évolue très peu (limite inférieure asymptotique). La surface A2 correspond à des surfaces de fabrication de point mémoire minimales de 10x10 nm². La première tension de forming minimale est obtenue pour le couple (d1, A1). La deuxième tension de forming maximale est obtenue pour le couple (d2, A2). La première tension de forming minimale et la deuxième tension de forming maximale permettent de prendre en compte la variabilité sur les tensions de forming, V_{FORMING}; avec un échantillonnage de 50 dispositifs, par exemple. La différence entre la première tension de forming minimale et la deuxième tension de forming maximale doit être supérieure ou égale à 1V (volt).
Les courbes des figures 5A et 7C sont représentées pour un empilement de TiN(35nm)/Hf02/Ti (10nm) TiN. Sur la figure 5A, sont représentées les tensions de forming en fonction des surfaces pour différentes épaisseurs de Hf02 (5, 10 et 15nm). La courbe de la figure 7C (zoom des courbes des figures 7A et 7B) montre que le couple (d1=10nm, d2=5nm) ne peut pas être retenu car le critère de la différence entre la première tension de forming minimale et la deuxième tension de forming maximale devant être supérieure ou égale à 1V n'est pas respecté.
En revanche, pour une épaisseur de Hf02 de 15nm, la tension VF1 est supérieure ou égale à 3,5V pour une surface A1 supérieure ou égale à 5 µm².
Pour le couple (d1=15nm, d2=5nm), le critère de la différence entre la première tension de forming minimale et la deuxième tension de forming maximale devant être supérieure ou égale à 1V est respecté (voir courbes 5A et 7C). Le couple (d1=13nm, d2=5nm) peut potentiellement être retenu si la différence entre la première tension de forming minimale et la deuxième tension de forming maximale est supérieure ou égale à 1V.
Alternativement, en partant d'un couple d'épaisseur (d1, d2), on pourra déterminer les surfaces A1, A2 pour lesquelles le critère de la différence entre la première tension de forming minimale et la deuxième tension de forming maximale devant être supérieure ou égale à 1V, est respecté.

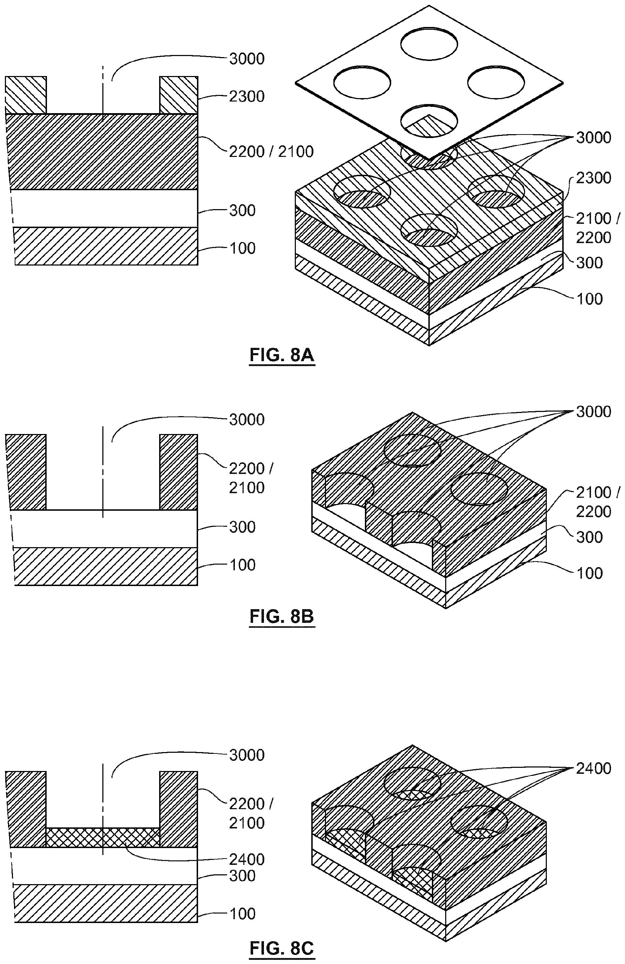

Les **figures 8A** à **8F** illustrent un exemple de réalisation d'une zone amincie localisée de l'oxyde en utilisant la lithographie dite « DSA » (acronyme en anglais pour « Direct Self Aligned ») à l'aide de copolymères de type di-blocs. Les figures 8A à 8C illustrent la formation de motifs de guidage 3000. Préalablement, on forme une première électrode 100.

Selon un exemple de réalisation, la première électrode 100 est à base de nitrure de titane (TiN), d'une épaisseur de 35 nm, formée par un dépôt physique en phase vapeur (acronyme PVD en anglais pour « physical vapor déposition »). On forme ensuite une couche d'oxyde 300, par exemple en utilisant un dépôt par couches atomiques (acronyme ALD en anglais pour « Atomic Layer Déposition »), à une température de préférence avoisinant les 300°C, d'une épaisseur de 10 nm. Selon un exemple, la couche d'oxyde 300 est à base d'oxyde d'hafnium (HfO2). Il s'ensuit une étape de formation d'un empilement comprenant, successivement à partir de la couche d'oxyde 300, une couche de SOC 2100 (acronyme en anglais pour « Spin on Carbon ») et de préférence une couche additionnelle par exemple une couche de SiARC 2200 (acronyme en anglais pour « Silicon Anti Reflective Coating »), d'une épaisseur de 20 nm, par exemple.

Une première étape illustrée en **figure 8A** est l'impression de motifs de guidage 3000 dans une couche de résine 2300, préalablement déposée sur la couche de SiARC 2200, de préférence photosensible, par le biais d'une lithographie, par exemple, de l'extrême Ultra-Violet (EUV) ou de l'e-beam ou toute autre technique de lithographie (connues en anglais sous les termes « nano-imprint », « soft-lithography », « multi-patterning », etc.).

Ces motifs de guidage 3000 sont ensuite transférés dans l'empilement de masques sous-jacent constitué, selon un exemple de réalisation, d'une couche de SiARC 2200 (acronyme en anglais pour « Silicon Anti Reflective Coating ») et d'une couche de SOC 2100 (acronyme en anglais pour « Spin on Carbon »), comme cela est illustré en **figure 8B****.** Cet empilement 2100, 2200, comprenant la couche de SiARC 2200 et la couche de SOC 2100, est avantageux notamment pour adapter l'indice de réfraction lors d'une exposition. Cette intégration est préférée dans le cadre de la présente invention. Toutefois, il est également possible d'utiliser directement la couche de résine 2300 comme motifs de guidage 3000 ou d'autres masques durs que l'empilement de SiARC 2200/SOC 2100, comme par exemple du nitrure de titane (TiN), du nitrure de silicium (SiN), de l'oxyde de silicium (SiO2), du nitrure de bore (BN), de la résine durcie par dépôt de masque dur. Les motifs de guidage 3000 réalisés peuvent être de différentes formes (par exemple de forme circulaire, elliptique ou autre) et différents pas. La hauteur des motifs de guidage 3000 (ou topographie de surface) mesurée sera par exemple de 130 nanomètres quelle que soit la densité desdits motifs de guidage 3000.

Une fois les motifs de guidage 3000 créés, on neutralise le substrat, soit la couche sous-jacente d'oxyde 300 en y greffant une couche de neutralisation 2400 **(****figure 8C****).** L'épaisseur de la couche de neutralisation 2400 peut, par exemple, être d'une dizaine de nanomètres d'épaisseur, de préférence de l'ordre de 10 nm. La couche de neutralisation 2400 peut être formée en un copolymère statistique, selon un exemple préféré du PS-*r*-PMMA (pour poly(styrène-*b*-méthacrylate de méthyle)), ou un homopolymère (par exemple, le polystyrène). Le greffage de cette couche de neutralisation 2400 se fait, de préférence, en trois étapes successives : un dépôt par enduction centrifuge (plus connue sous le terme anglais « spin-coating », un recuit et un rinçage. Cette étape est avantageuse afin que les cylindres des copolymères diblocs s'orientent verticalement par rapport à la surface à l'intérieur des motifs de guidage 3000, lors du recuit d'organisation.

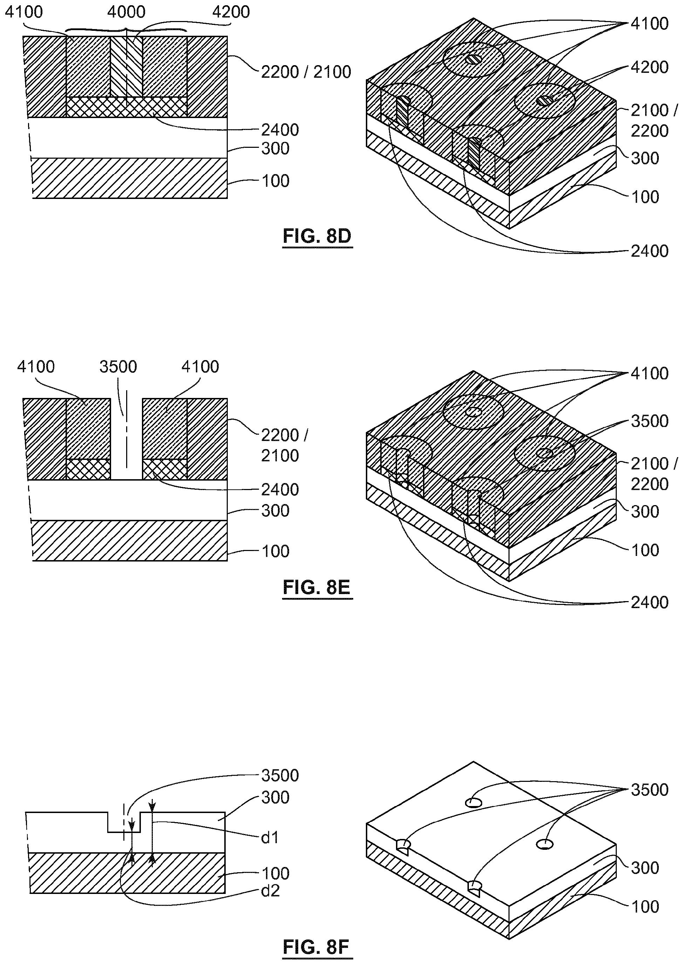

Après les étapes de formation des motifs de guidage 3000, il s'ensuit une étape d'auto-assemblage des copolymères diblocs 4000, tel qu'illustré en **figure 8D****.** Les copolymères diblocs 4000 peuvent être, selon un exemple préféré, du PS-b-PMMA (pour poly(styrène-*b*-méthacrylate de méthyle)) comprenant un premier polymère le polystyrène PS 4100 et un deuxième polymère le polyméthacrylate de méthyle PMMA 4200. Le dépôt des copolymères diblocs 4000 se fait, par exemple, par enduction centrifuge (en anglais « spin coating »). Ainsi, les paramètres, lors du dépôt des copolymères diblocs 4000 par la technique d'enduction centrifuge (la vitesse de rotation (par exemple : 1500 rpm), la concentration de la solution (par exemple 1,5%), la durée de rotation, la densité du polymère) doivent être judicieusement choisis pour permettre d'avoir une épaisseur contrôlée à l'intérieur des motifs de guidage 3000. L'étape d'enduction centrifuge sera suive d'une étape de recuit thermique (par exemple effectuée à une température de 250°C pendant 5 min sous d'azote (N2)), permettant l'auto-organisation des copolymères diblocs 4000.

La **figure 8E** illustre la réalisation d'un motif en creux, tel qu'un trou 3500 dans la matrice du premier polymère 4100 à base de polystyrène PS des motifs de guidage 3000. Le deuxième polymère 4200 à base de polyméthacrylate de méthyle est éliminé sélectivement par rapport au premier polymère 4100 à base de polystyrène et par rapport à l'empilement comprenant la couche de SiARC 2200 et la couche de SOC 2100. Le retrait du deuxième polymère 4200 est réalisé, par exemple, à l'aide d'acide acétique. Ensuite, la couche de neutralisation 2400 est gravée au travers des trous 3500 de la matrice du premier polymère 4100.

La **figure 8F** illustre le transfert de motifs en creux, tels que des trous 3500 dans la couche d'oxyde 300 sous-jacente. Les motifs des trous 3500 formés dans le premier polymère 4100 sont transférés partiellement dans la couche d'oxyde 300. Pour ce faire, on réalise une gravure de la couche d'oxyde 300, par exemple à base de HfO2. Dans le mode de réalisation illustré cette gravure est partielle. Elle présente alors par exemple une gravure sur une épaisseur de 5 nm, à l'aide d'une chimie comprenant du BCl3/Cl2 par exemple.

Selon un autre mode de réalisation non illustré et qui sera décrit plus en détail par la suite on réalise une gravure de la couche d'oxyde 300 sur toute son épaisseur au droit des motifs des trous 3500.

On procède ensuite au retrait du premier polymère PS 4100, de la couche de neutralisation 2400, de la couche de SiARC 2200 et de la couche de SOC 2100 de sorte à laisser en place la couche d'oxyde pourvue d'une zone amincie comprenant une épaisseur d2 ; l'épaisseur d2 étant inférieure à l'épaisseur d1 de la couche d'oxyde 300, initialement déposée.
Enfin, on forme une deuxième électrode 200 (non illustré) sous forme de bicouche de titane d'une épaisseur de 10nm et de nitrure de titane d'une épaisseur de 50nm.

Selon un autre mode de réalisation alternatif relativement aux figures 8A à 8F, une première couche d'oxyde, par exemple à base de HfO2, est formée sur la première électrode 100. La première couche d'oxyde comprend une épaisseur e1. On effectue ensuite les même étapes que celles illustrées sur la figures 8A à 8E, la première couche d'oxyde remplaçant la couche d'oxyde 300. Le transfert de trous 3500 dans la couche d'oxyde 300 sous-jacente est ensuite effectué. Les motifs des trous 3500 formés dans le premier polymère 4100 sont transférés dans la couche d'oxyde 300. Contrairement à ce qui est illustré en figure 8F, on réalise une gravure totale (et non pas partielle) de toute l'épaisseur e1 de la première couche d'oxyde de sorte à atteindre la première électrode 100 au niveau des motifs des trous 3500. La première couche d'oxyde est donc mise à nu au niveau d'une zone destinée à définir la deuxième zone 302.

On procède ensuite au retrait du premier polymère PS 4100, de la couche de neutralisation 2400, de la couche de SiARC 2200 et de la couche de SOC 2100 de sorte à laisser en place la première couche d'oxyde pourvue d'une zone débouchant sur la première électrode 100. Ensuite une deuxième couche d'oxyde, par exemple à base de HfO2, est formée de sorte à recouvrir la première couche d'oxyde. La deuxième couche d'oxyde comprend une épaisseur d2. La deuxième couche d'oxyde est ensuite recouverte par une deuxième électrode 200. Ainsi, dans une première zone 301, les électrodes 100, 200 sont séparées d'une distance d1, correspondant à la somme de l'épaisseur e1 de la première couche d'oxyde et de l'épaisseur d2 de la deuxième couche d'oxyde. Dans une deuxième zone 302, les électrodes 100, 200 sont séparées d'une distance d2, correspondant à l'épaisseur d2 de la deuxième couche d'oxyde. Avantageusement, la première zone 301 entoure la deuxième zone 302. Selon un autre mode de réalisation, la première zone 301 est située de part et d'autre de la deuxième zone 302. Avantageusement, la distance d2 est inférieure à la distance d1.

De manière particulièrement avantageuse, le précédent mode de réalisation comprenant une première couche d'oxyde et une deuxième couche d'oxyde proposent un dispositif où la première couche d'oxyde est complètement retirée dans la zone amincie 302, avant que soit déposée une deuxième couche d'oxyde de l'épaisseur d2 souhaitée. Ainsi, la couche d'oxyde, c'est-à-dire la deuxième couche d'oxyde, de la zone amincie 302 sera « intègre » et pas modifiée potentiellement en surface par la chimie de gravure utilisée lors d'étapes ultérieures du procédé.

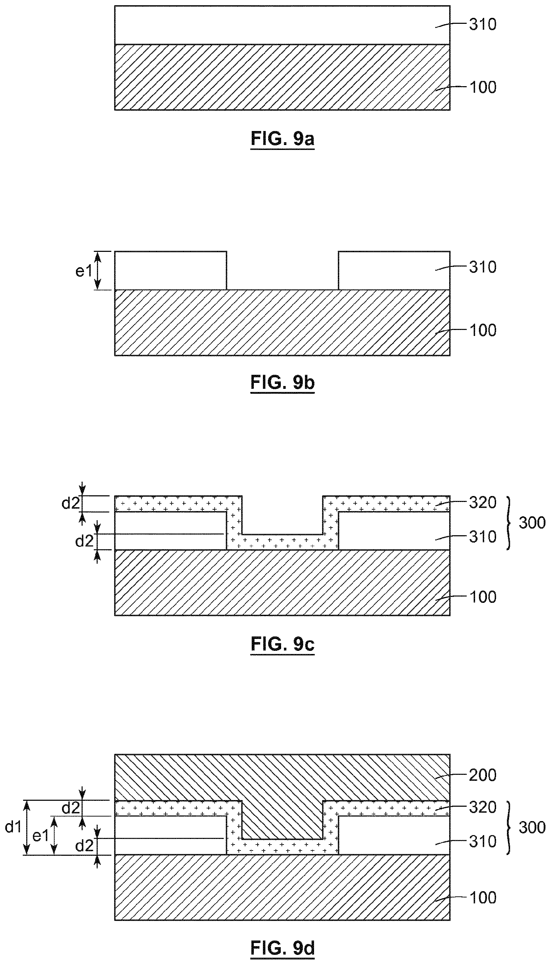

Un autre mode de réalisation d'un dispositif selon l'invention va maintenant être décrit en référence aux figures 9A à 9D.

Selon ce mode de réalisation alternatif, une première couche d'oxyde 310, par exemple à base de HfO2, est formée sur la première électrode 100 par exemple par dépôt ou par report (figure 9A). La première couche d'oxyde 310 présente une épaisseur e1. Cette couche 310 est de préférence conforme.

On effectue ensuite une étape de retrait (figure 9B) de toute l'épaisseur de la première couche 310 dans une zone destinée à former la deuxième zone 302.

Ce retrait peut être effectué par une étape de lithographie, par exemple par faisceau d'électrons ou par dépôt d'un masque puis insolation et gravure. Ce retrait forme un motif 900 dans la première couche 310. Ce retrait étant effectué sur toute l'épaisseur e1 de la première couche d'oxyde 310, le motif 900 est débouchant sur la première électrode 100. Cette dernière est donc mise à nu au niveau de la deuxième zone 302. En dehors de la première zone, la première couche d'oxyde 310 est non gravée ou gravée dans une bien moindre mesure de sorte à continuer à recouvrir l'électrode 100.

Les couches d'oxyde 310 et 320 forment ainsi la couche d'oxyde 300.

Ensuite une deuxième couche d'oxyde 320, par exemple à base de HfO2, est formée de sorte à recouvrir la première couche d'oxyde 310 (figure 9C). La deuxième couche d'oxyde 320 présente une épaisseur d2. Le dépôt de la deuxième couche d'oxyde 320 est de préférence conforme. La deuxième couche d'oxyde 320 est ensuite recouverte par une deuxième électrode 200 (figure 9D).

Ainsi, dans une première zone 301, les électrodes 100, 200 sont séparées d'une distance d1, correspondant à la somme de l'épaisseur e1 de la première couche d'oxyde 310 et de l'épaisseur d2 de la deuxième couche d'oxyde 320. La distance d2 est inférieure à la distance d1. Dans une deuxième zone 302 où est formé le motif 900, les électrodes 100, 200 sont séparées d'une distance d2, correspondant à l'épaisseur d2 de la deuxième couche d'oxyde 320. Avantageusement, la première zone 301 entoure la deuxième zone 302. Selon un autre mode de réalisation, la première zone 301 est située de part et d'autre de la deuxième zone 302.

La distance d2 est donc uniquement contrôlée par l'épaisseur du dépôt de la deuxième couche. Cette épaisseur peut ainsi être contrôlée très précisément.

Par ailleurs, les deux surfaces de la couche d'oxyde au niveau de la deuxième couche est intègre. En particulier, la face au regard de l'électrode 200 n'a pas été endommagée par une gravure. Les performances du dispositif en sont améliorées.

La présente invention propose ainsi un procédé de réalisation permettant de former un dispositif mémoire dont la stabilité des performances cycles après cycles peut être potentiellement améliorée par la détermination d'un rapport entre la distance nominale d1, d2 entre les électrodes 100, 200 et la surface de contact des électrodes 100, 200 avec la couche d'oxyde 300.

## Revendications

1. Dispositif mémoire comprenant une couche d'oxyde (300) disposée entre une première électrode (100) et une deuxième électrode (200),
la couche d'oxyde (300) présentant une première zone (301) et une deuxième zone (302), la première zone (301) entourant ou étant située de part et d'autre de la deuxième zone (302), la distance minimale d2 séparant les première et deuxième électrodes (100, 200) au niveau de la deuxième zone (302) de la couche d'oxyde (300) étant inférieure à la distance minimale d1 séparant les première et deuxième électrodes (100, 200) au niveau de la première zone (301) de la couche d'oxyde (300),
**caractérisé en ce que** le ratio entre la surface d'au moins une électrode (100, 200) parmi les première et deuxième électrodes (100, 200) située au regard de la deuxième zone (302) et la surface de cette électrode (100, 200) parmi les première et deuxième électrodes (100, 200) située au regard de la première zone (301) est compris entre 0,0001 et 0,5.

2. Dispositif selon la revendication précédente, dans lequel le ratio entre la distance minimale d2 et la distance minimale d1 est compris entre 0,2 et 0,7.

3. Dispositif selon l'une quelconque des revendications précédentes, dans lequel au moins une électrode (100, 200) parmi les première et deuxième électrodes (100, 200) est située au contact de la deuxième zone (302) au moins dans la deuxième zone et dans lequel le ratio entre d'une part la surface par laquelle cette électrode (100, 200) est au regard de la deuxième zone (302) et d'autre part la surface par laquelle cette électrode (100, 200) est située au regard de la première zone (301) est compris entre 0,0001 et 0,5.

4. Dispositif selon l'une quelconque des revendications précédentes, dans lequel l'une au moins parmi les première et deuxième électrodes (100, 200) est une électrode non inerte apte à réagir avec la couche d'oxyde (300) de sorte à créer des lacunes d'oxygène ou défauts (600) dans ladite couche d'oxyde (300) lorsqu'une tension est appliquée au dispositif.

5. Dispositif selon la revendication précédente, dans lequel la couche d'oxyde (300) est au contact direct de ladite au moins une électrode non inerte (200) au niveau de la deuxième zone (302) et au niveau de la première zone (301).

6. Dispositif selon l'une quelconque des deux revendications précédentes, dans lequel la surface de ladite au moins une électrode non inerte (200) située au regard de la première zone (301) est comprise entre 0,01 et 10 micromètres carré.

7. Dispositif selon l'une quelconque des trois revendications précédentes, dans lequel la surface de ladite au moins une électrode non inerte (200) située au regard de la deuxième zone (302) est comprise entre 0,0001 et 0,25 micromètres carré.

8. Dispositif selon l'une quelconque des quatre revendications précédentes, dans lequel la couche d'oxyde (300) est au contact direct de l'une des deux électrodes (100, 200) au niveau de la deuxième zone (302) et comprend au moins une couche intermédiaire (700) entre la couche d'oxyde (300) et cette même électrode non inerte (200) au niveau de la première zone (301).

9. Dispositif selon l'une quelconque des revendications précédentes, dans lequel la couche d'oxyde (300) comprend une première couche d'oxyde (310) et une deuxième couche d'oxyde (320) surmontant la première couche d'oxyde (310) et dans lequel la distance minimale d2 séparant les première et deuxième électrodes (100, 200) au niveau de la deuxième zone (302) est égale à l'épaisseur de la deuxième couche d'oxyde (320).

10. Dispositif selon l'une quelconque des revendications précédentes, dans lequel d1 est comprise entre 5 et 20 nm et de préférence entre 5 et 15 nm.

11. Dispositif selon l'une quelconque des revendications précédentes, dans lequel d2 est comprise entre 2 et 15 nm et de préférence entre 2 et 10 nm.

12. Dispositif selon l'une quelconque des revendications précédentes, dans lequel d1 est comprise entre 5 et 15 nm, d2 est comprise entre 2 et 10 nm, dans lequel la surface d'au moins une électrode (200) parmi les première et deuxième électrodes (100, 200) située au regard de la première zone (301) est comprise entre 0,01 et 10 micromètres carré et dans lequel la surface de cette électrode (200) parmi les première et deuxième électrodes (100, 200) située au regard de la deuxième zone (302) est comprise entre 0,0001 et 0,25 micromètres carré.

13. Dispositif selon l'une quelconque des revendications précédentes, dans lequel au moins l'une parmi la première et la deuxième électrode (100, 200) s'étend principalement dans un plan et dans lequel la deuxième zone (302) de la couche d'oxyde (300) est délimitée par des flancs qui s'étendent perpendiculairement audit plan.

14. Procédé de réalisation d'un dispositif mémoire comprenant la formation d'une couche d'oxyde (300) disposée entre une première électrode et une deuxième électrode (100, 200),
la formation de la couche d'oxyde (300) étant réalisée de sorte à ce que la couche d'oxyde (300) présente une première zone (301) et une deuxième zone (302), la première zone (301) entourant ou étant située de part et d'autre de la deuxième zone (302), la distance minimale d2 séparant les première et deuxième électrodes (100, 200) au niveau de la deuxième zone (302) de la couche d'oxyde (300) étant inférieure à la distance minimale d1 séparant les deux électrodes (100, 200) au niveau de la première zone (301) de la couche d'oxyde (300),
le procédé comprenant une étape préalable de localisation de la formation d'au moins un filament conducteur (500) dans la deuxième zone (302) lorsqu'une tension est appliquée au dispositif en fonction des distances d1, d2 et en fonction de la surface d'au moins une électrode (200) parmi les première et deuxième électrodes (100, 200) située au regard de la première zone (301) et en fonction du ratio entre la surface par laquelle au moins une électrode parmi les première et deuxième électrodes (100, 200) est située au regard de la première zone (301) et la surface par laquelle cette même électrode est située au regard de la deuxième zone (302), **caractérisé en ce que** l'étape de localisation comprend la détermination d'un ratio entre d'une part la surface par laquelle au moins une électrode parmi les première et deuxième électrodes (100, 200) est située au regard de la première zone (301) et d'autre part la surface par laquelle cette même électrode (100, 200) est située au regard de la deuxième zone (302), le ratio étant compris entre 0,0001 et 0,5.

15. Procédé selon la revendication précédente, dans lequel l'étape de localisation comprend la détermination d'un ratio entre la distance d2 et la distance d1, compris entre 0,2 et 0,7, de manière à ce que le filament conducteur (500) se forme dans la deuxième zone (302).

16. Procédé selon l'une quelconque des deux revendications précédentes, dans lequel l'étape de formation de la couche d'oxyde (300) réalisée de sorte à ce que la couche d'oxyde (300) présente une première zone (301) et une deuxième zone (302) comprend au moins les étapes suivantes :
- la formation d'une couche d'oxyde (300) sur une électrode parmi les première et deuxième électrodes (100, 200);
- une étape d'amincissement de la couche d'oxyde (300) de manière à former la deuxième zone (302) ;
le procédé comprenant ensuite le dépôt de l'autre électrode parmi les première et deuxième électrodes (100, 200) sur la première couche d'oxyde (300), de préférence l'épaisseur de la couche d'oxyde (300), après l'étape d'amincissement et au niveau de la zone (302), présentant une épaisseur égale à la distance minimale d2.

17. Procédé selon l'une quelconque des revendications 14 à 15, dans lequel l'étape de formation de la couche d'oxyde (300) réalisée de sorte à ce que la couche d'oxyde (300) présente une première zone (301) et une deuxième zone (302) comprend au moins les étapes suivantes :
- la formation d'une première couche d'oxyde (310) sur une électrode parmi les première et deuxième électrodes (100, 200);
- le retrait de toute l'épaisseur de la première couche d'oxyde (310) uniquement au niveau de la deuxième zone (302) de manière à mettre à nu ladite électrode parmi les première et deuxième électrodes (100, 200) au niveau de la deuxième zone (302);
- le dépôt d'une deuxième couche d'oxyde (320) sur la première couche d'oxyde (310) et sur ladite électrode parmi les première et deuxième électrodes (100, 200) mise à nu au niveau de la deuxième zone (302);
le procédé comprenant ensuite le dépôt de l'autre électrode parmi les première et deuxième électrodes (100, 200), de préférence l'épaisseur de la deuxième couche telle que déposée est égale à la distance minimale d2.

18. Procédé selon la revendication 14, dans lequel
- l'étape de formation de la couche d'oxyde (300) réalisée de sorte à ce que la couche d'oxyde (300) présente une première zone (301) et une deuxième zone (302) comprend au moins la formation d'une première couche d'oxyde (310) sur une électrode parmi les première et deuxième électrodes (100, 200);
- la formation d'au moins une couche de masquage (2100, 2200, 2300) et la réalisation de motifs de guidage (3000) dans la couche de masquage (2100, 2200, 2300) ;
- le dépôt d'un copolymère di-bloc (4000) dans les motifs de guidage (3000), le copolymère di-bloc (4000) étant apte à former dans chaque motif de guidage (3000) un premier polymère (4100) et un deuxième polymère (4200), le premier polymère (4100) entourant le ou étant situé de part et d'autre du deuxième polymère (4200) ;
- le retrait complet du deuxième polymère (4200) en laissant en place le premier polymère (4100) de manière à former un motif en creux (3500) au droit de la couche d'oxyde (300);
- la gravure de la couche d'oxyde (300) située au droit du motif en creux (3500) ;
- le retrait du premier polymère (4100);
- la formation de l'autre électrode parmi les première et deuxième électrodes (100, 200) ;

19. Procédé selon la revendication précédente, dans lequel l'étape de gravure de la couche d'oxyde (300) située au droit du motif en creux (3500) est effectuée soit de manière à graver seulement partiellement l'épaisseur de la couche d'oxyde (300) et à conserver une portion d'épaisseur de la couche d'oxyde (300), cette portion d'épaisseur définissant la distance minimale d2, soit de manière à graver entièrement l'épaisseur de la couche d'oxyde (300) de sorte à mettre à nu l'électrode sur laquelle repose la couche d'oxyde (300) dans une zone destinée à former la deuxième zone (302) ; le procédé selon cette deuxième alternative comprenant, après le retrait du premier polymère (4100) et avant la formation de l'autre électrode parmi les première et deuxième électrodes (100, 200), une étape de dépôt d'une autre couche d'oxyde, notamment dans la zone destinée à former la deuxième zone (302), l'épaisseur de ladite autre couche d'oxyde définissant la distance minimale d2.

20. Dispositif microélectronique comprenant une pluralité de dispositifs mémoire selon l'une quelconque des revendications 1 à 13.

## Patentansprüche

1. Speichervorrichtung mit einer Oxidschicht (300), die zwischen einer ersten Elektrode (100) und einer zweiten Elektrode (200) angeordnet ist,
wobei die Oxidschicht (300) einen ersten Bereich (301) und einen zweiten Bereich (302) aufweist, wobei der erste Bereich (301) den zweiten Bereich (302) umgibt bzw. beiderseits desselben liegt, wobei der Mindestabstand d2, der die erste und die zweite Elektrode (100, 200) in Höhe des zweiten Bereichs (302) der Oxidschicht (300) trennt, geringer ist als der Mindestabstand d1, der die erste und die zweite Elektrode (100, 200) in Höhe des ersten Bereichs (301) der Oxidschicht (300) trennt,
**dadurch gekennzeichnet, dass**
das Verhältnis zwischen der dem zweiten Bereich (302) gegenüberliegenden Fläche zumindest einer Elektrode (100, 200) aus erster und zweiter Elektrode (100, 200) und der dem ersten Bereich (301) gegenüberliegenden Fläche dieser Elektrode (100, 200) aus erster und zweiter Elektrode (100, 200) zwischen 0,0001 und 0,5 beträgt.

2. Vorrichtung nach dem vorangehenden Anspruch, wobei das Verhältnis zwischen dem Mindestabstand d2 und dem Mindestabstand d1 zwischen 0,2 und 0,7 beträgt.

3. Vorrichtung nach einem der vorangehenden Ansprüche, wobei zumindest eine Elektrode (100, 200) aus erster und zweiter Elektrode (100, 200) zumindest im zweiten Bereich in Kontakt mit dem zweiten Bereich (302) steht und wobei das Verhältnis zwischen einerseits der Fläche, mit welcher diese Elektrode (100, 200) dem zweiten Bereich (302) gegenüberliegt, und andererseits der Fläche, mit welcher diese Elektrode (100, 200) dem ersten Bereich (301) gegenüberliegt, zwischen 0,0001 und 0,5 beträgt.

4. Vorrichtung nach einem der vorangehenden Ansprüche, wobei zumindest eine aus erster und zweiter Elektrode (100, 200) eine nicht inerte Elektrode ist, die dazu geeignet ist, mit der Oxidschicht (300) so zu reagieren, dass bei Anlegen einer Spannung an die Vorrichtung Sauerstofflücken bzw. -Fehlstellen (600) in der Oxidschicht (300) entstehen.

5. Vorrichtung nach dem vorangehenden Anspruch, wobei die Oxidschicht (300) in Höhe des zweiten Bereichs (302) und in Höhe des ersten Bereichs (301) direkt in Kontakt mit der zumindest einen nicht inerten Elektrode (200) steht.

6. Vorrichtung nach einem der beiden vorangehenden Ansprüche, wobei die dem ersten Bereich (301) gegenüberliegende Fläche der zumindest einen nicht inerten Elektrode (200) zwischen 0,01 und 10 Quadratmikrometer beträgt.

7. Vorrichtung nach einem der drei vorangehenden Ansprüche, wobei die dem zweiten Bereich (302) gegenüberliegende Fläche der zumindest einen nicht inerten Elektrode (200) zwischen 0,0001 und 0,25 Quadratmikrometer beträgt.

8. Vorrichtung nach einem der vier vorangehenden Ansprüche, wobei die Oxidschicht (300) in Höhe des zweiten Bereichs (302) direkt in Kontakt mit einer der beiden Elektroden (100, 200) steht und in Höhe des ersten Bereichs (301) zumindest eine Zwischenschicht (700) zwischen der Oxidschicht (300) und dieser gleichen nicht inerten Elektrode (200) enthält.

9. Vorrichtung nach einem der vorangehenden Ansprüche, wobei die Oxidschicht (300) eine erste Oxidschicht (310) und eine zweite Oxidschicht (320) enthält, welche die erste Oxidschicht (310) überragt, und wobei der Mindestabstand d2, der die erste und die zweite Elektrode (100, 200) in Höhe des zweiten Bereichs (302) trennt, gleich der Dicke der zweiten Oxidschicht (320) ist.

10. Vorrichtung nach einem der vorangehenden Ansprüche, wobei d1 zwischen 5 und 20 nm und vorzugsweise zwischen 5 und 15 nm beträgt.

11. Vorrichtung nach einem der vorangehenden Ansprüche, wobei d2 zwischen 2 und 15 nm und vorzugsweise zwischen 2 und 10 nm beträgt.

12. Vorrichtung nach einem der vorangehenden Ansprüche, wobei d1 zwischen 5 und 15 nm beträgt und d2 zwischen 2 und 10 nm beträgt, wobei die dem ersten Bereich (301) gegenüberliegende Fläche zumindest einer Elektrode (200) aus erster und zweiter Elektrode (100, 200) zwischen 0,01 und 10 Quadratmikrometer beträgt und wobei die dem zweiten Bereich (302) gegenüberliegende Fläche dieser Elektrode (200) aus erster und zweiter Elektrode (100, 200) zwischen 0,0001 und 0,25 Quadratmikrometer beträgt.

13. Vorrichtung nach einem der vorangehenden Ansprüche, wobei zumindest eine aus erster und zweiter Elektrode (100, 200) sich hauptsächlich in einer Ebene erstreckt und wobei der zweite Bereich (302) der Oxidschicht (300) von Flanken begrenzt wird, die sich senkrecht zur genannten Ebene erstrecken.

14. Verfahren zum Herstellen einer Speichervorrichtung, umfassend das Ausbilden einer Oxidschicht (300), die zwischen einer ersten Elektrode und einer zweiten Elektrode (100, 200) angeordnet ist,
wobei das Ausbilden der Oxidschicht (300) so erfolgt, dass die Oxidschicht (300) einen ersten Bereich (301) und einen zweiten Bereich (302) aufweist, wobei der erste Bereich (301) den zweiten Bereich (302) umgibt bzw. beiderseits desselben liegt, wobei der Mindestabstand d2, der die erste und die zweite Elektrode (100, 200) in Höhe des zweiten Bereichs (302) der Oxidschicht (300) trennt, geringer ist als der Mindestabstand d1, der die beiden Elektroden (100, 200) in Höhe des ersten Bereichs (301) der Oxidschicht (300) trennt,
wobei das Verfahren einen vorherigen Schritt des Lokalisierens der Ausbildung zumindest eines leitfähigen Filaments (500) in dem zweiten Bereich (302) bei Anlegen einer Spannung an die Vorrichtung in Abhängigkeit von den Abständen d1, d2 und in Abhängigkeit von der dem ersten Bereich (301) gegenüberliegenden Fläche zumindest einer Elektrode (200) aus erster und zweiter Elektrode (100, 200) und in Abhängigkeit von dem Verhältnis zwischen der Fläche, mit welcher zumindest eine Elektrode aus erster und zweiter Elektrode (100, 200) dem ersten Bereich (301) gegenüberliegt, und der Fläche, mit welcher diese gleiche Elektrode am zweiten Bereich (302) gegenüberliegt, umfasst,
**dadurch gekennzeichnet, dass**
der Schritt des Lokalisierens das Ermitteln von einem Verhältnis zwischen einerseits der Fläche, mit welcher zumindest eine Elektrode aus erster und zweiter Elektrode (100, 200) dem ersten Bereich (301) gegenüberliegt, und andererseits der Fläche, mit welcher diese gleiche Elektrode (100, 200) dem zweiten Bereich (302) gegenüberliegt, umfasst, wobei dieses Verhältnis zwischen 0,0001 und 0,5 beträgt.

15. Verfahren nach dem vorangehenden Anspruch, wobei der Schritt des Lokalisierens das Ermitteln von einem Verhältnis zwischen dem Abstand d2 und dem Abstand d1, das zwischen 0,2 und 0,7 beträgt, umfasst, so dass das leitfähige Filament (500) sich in dem zweiten Bereich (302) bildet.

16. Verfahren nach einem der beiden vorangehenden Ansprüche, wobei der Schritt des Ausbildens der Oxidschicht (300), der so erfolgt, dass die Oxidschicht (300) einen ersten Bereich (301) und einen zweiten Bereich (302) aufweist, zumindest die nachstehenden Schritte umfasst:
- Ausbilden einer Oxidschicht (300) an einer Elektrode aus erster und zweiter Elektrode (100, 200);
- einen Schritt des Verjüngens der Oxidschicht (300) so, dass der zweite Bereich (302) gebildet wird;
wobei das Verfahren dann das Aufbringen der anderen Elektrode aus erster und zweiter Elektrode (100, 200) auf die erste Oxidschicht (300) umfasst, wobei vorzugsweise die Dicke der Oxidschicht (300) nach dem Schritt des Verjüngens und in Höhe des Bereichs (302) eine Dicke aufweist, die gleich dem Mindestabstand d2 ist.

17. Verfahren nach einem der Ansprüche 14 bis 15, wobei der Schritt des Ausbildens der Oxidschicht (300), der so erfolgt, dass die Oxidschicht (300) einen ersten Bereich (301) und einen zweiten Bereich (302) aufweist, zumindest die nachstehenden Schritte umfasst:
- Ausbilden einer ersten Oxidschicht (310) an einer Elektrode aus erster und zweiter Elektrode (100, 200);
- Entfernen der gesamten Dicke der ersten Oxidschicht (310) nur in Höhe des zweiten Bereichs (302), derart, dass die genannte Elektrode aus erster und zweiter Elektrode (100, 200) in Höhe des zweiten Bereichs (302) freigelegt wird;
- Aufbringen einer zweiten Oxidschicht (320) auf die erste Oxidschicht (310) und auf die in Höhe des zweiten Bereichs (302) freigelegte Elektrode aus erster und zweiter Elektrode (100, 200);
wobei das Verfahren dann das Aufbringen der anderen Elektrode aus erster und zweiter Elektrode (100, 200) umfasst, wobei vorzugsweise die Dicke der zweiten Schicht - wie aufgebracht - gleich dem Mindestabstand d2 ist.

18. Verfahren nach Anspruch 14, wobei
- der Schritt des Ausbildens der Oxidschicht (300), der so erfolgt, dass die Oxidschicht (300) einen ersten Bereich (301) und einen zweiten Bereich (302) aufweist, zumindest das Ausbilden einer ersten Oxidschicht (310) an einer Elektrode aus erster und zweiter Elektrode (100, 200) umfasst;
- Ausbilden zumindest einer Maskierungsschicht (2100, 2200, 2300) und Herstellen von Führungsmustern (3000) in der Maskierungsschicht (2100, 2200, 2300);
- Aufbringen eines Diblockcopolymers (4000) in den Führungsmustern (3000), wobei das Diblockcopolymer (4000) dazu geeignet ist, in jedem Führungsmuster (3000) ein erstes Polymer (4100) und ein zweites Polymer (4200) auszubilden, wobei das erste Polymer (4100) das zweite Polymer (4200) umgibt bzw. beiderseits desselben liegt;
- vollständiges Entfernen des zweiten Polymers (4200), indem das erste Polymer (4100) an Ort und Stelle belassen wird, so dass im Bereich der Oxidschicht (300) ein vertieftes Muster (3500) gebildet wird;
- Ätzen der im Bereich des vertieften Musters (3500) liegenden Oxidschicht (300);
- Entfernen des ersten Polymers (4100);
- Ausbilden der anderen Elektrode aus erster und zweiter Elektrode (100, 200).

19. Verfahren nach dem vorangehenden Anspruch, wobei der Schritt des Ätzens der Oxidschicht (300) im Bereich des vertieften Musters (3500) entweder so erfolgt, dass die Dicke der Oxidschicht (300) nur teilweise geätzt wird und ein Dickenabschnitt der Oxidschicht (300) beibehalten wird, wobei dieser Dickenabschnitt den Mindestabstand d2 definiert, oder so erfolgt, dass die Dicke der Oxidschicht (300) vollständig geätzt wird, so dass die Elektrode, auf welcher die Oxidschicht (300) aufliegt, in einem Bereich freigelegt wird, der dazu bestimmt ist, den zweiten Bereich (302) zu bilden; wobei das Verfahren gemäß dieser zweiten Variante nach dem Entfernen des ersten Polymers (4100) und vor dem Ausbilden der anderen Elektrode aus erster und zweiter Elektrode (100, 200) einen Schritt des Aufbringens einer weiteren Oxidschicht insbesondere in dem Bereich umfasst, der dazu bestimmt ist, den zweiten Bereich (302) zu bilden, wobei die Dicke der weiteren Oxidschicht den Mindestabstand d2 definiert.

20. Mikroelektronische Vorrichtung mit einer Mehrzahl von Speichervorrichtungen nach einem der Ansprüche 1 bis 13.

## Claims

1. Memory device comprising an oxide layer (300) arranged between a first electrode (100) and a second electrode (200),
the oxide layer (300) having a first zone (301) and a second zone (302), with the first zone (301) surrounding or being located on either side of the second zone (302), with the minimum distance d2 separating the first and second electrodes (100, 200) on the second zone (302) of the oxide layer (300) being less than the minimum distance d1 separating the first and second electrodes (100, 200) on the first zone (301) of the oxide layer (300),
**characterized in that** the ratio between the surface of at least one electrode (100, 200) among the first and second electrodes (100, 200) located facing the second zone (302) and the surface of this electrode (100, 200) among the first and second electrodes (100, 200) located facing the first zone (301) is comprised between 0.0001 and 0.5.

2. Device according to the preceding claim, wherein the ratio between the minimum distance d2 and the minimum distance d1 is comprised between 0.2 and 0.7.

3. Device according to any of the preceding claims, wherein at least one electrode (100, 200) among the first and second electrodes (100, 200) is located in contact with the second zone (302) at least in the second zone and wherein the ratio between on the one hand the surface through which this electrode (100, 200) is facing the second zone (302) and on the other hand the surface through which this electrode (100, 200) is located facing the first zone (301) is comprised between 0.0001 and 0.5.

4. Device according to any of the preceding claims, wherein at least one of the first and second electrodes (100, 200) is a non-inert electrode able to react with the oxide layer (300) in such a way as to create oxygen vacancies or defects (600) in said oxide layer (300) when a voltage is applied to the device.

5. Device according to the preceding claim, wherein the oxide layer (300) is in direct contact with said at least one non-inert electrode (200) on the second zone (302) and on the first zone (301).

6. Device according to any of the two preceding claims, wherein the surface of said at least one non-inert electrode (200) located facing the first zone (301) is comprised between 0.01 and 10 square micrometers.

7. Device according to any of the three preceding claims, wherein the surface of said at least one non-inert electrode (200) located facing the second zone (302) is comprised between 0.0001 and 0.25 square micrometers.

8. Device according to any of the four preceding claims, wherein the oxide layer (300) is in direct contact with one of the two electrodes (100, 200) on the second zone (302) and comprises at least one intermediate layer (700) between the oxide layer (300) and this same non-inert electrode (200) on the first zone (301).

9. Device according to any of the preceding claims, wherein the oxide layer (300) comprises a first oxide layer (310) and a second oxide layer (320) overmounting the first oxide layer (310) and wherein the minimum distance d2 that separates the first and second electrodes (100, 200) on the second zone (302) is equal to the thickness of the second oxide layer (320).

10. Device according to any of the preceding claims, wherein d1 is comprised between 5 and 20 nm and preferably between 5 and 15 nm.

11. Device according to any of the preceding claims, wherein d2 is comprised between 2 and 15 nm and preferably between 2 and 10 nm.

12. Device according to any of the preceding claims, wherein d1 is comprised between 5 and 15 nm, d2 is comprised between 2 and 10 nm, wherein the surface of at least one electrode (200) among the first and second electrodes (100, 200) located facing the first zone (301) is comprised between 0.01 and 10 square micrometers and wherein the surface of this electrode (200) among the first and second electrodes (100, 200) located facing the second zone (302) is comprised between 0.0001 and 0.25 square micrometers.

13. Device according to any of the preceding claims, wherein at least one among the first and second electrode (100, 200) extends mainly in a plane and wherein the second zone (302) of the oxide layer (300) is delimited by flanks that extend perpendicularly to said plane.

14. Method for realizing a memory device comprising the formation of an oxide layer (300) arranged between a first electrode and a second electrode (100, 200),
the formation of the oxide layer (300) being carried out in such a way that the oxide layer (300) has a first zone (301) and a second zone (302), with the first zone (301) surrounding or being located on either side of the second zone (302), with the minimum distance d2 separating the first and second electrodes (100, 200) on the second zone (302) of the oxide layer (300) being less than the minimum distance d1 separating the two electrodes (100, 200) on the first zone (301) of the oxide layer (300),
the method comprising a prior step of locating the formation of at least one conductive filament (500) in the second zone (302) is carried out when a voltage is applied to the device according to the distances d1, d2 and according to the surface of at least one electrode (200) among the first and second electrodes (100, 200) located facing the first zone (301) and according to the ratio between the surface through which at least one electrode among the first and second electrodes (100, 200) is located facing the first zone (301) and the surface through which this same electrode is located facing the second zone (302),
**characterized in that** the step of locating comprises the determination of a ratio between on the one hand the surface via which at least one electrode among the first and second electrodes (100, 200) is located facing the second zone (302) and on the other hand the surface via which this same electrode (100, 200) is located facing the first zone (301), with the ratio being between 0.0001 and 0.5.

15. Method according to the preceding claim, wherein the step of locating comprises the determination of a ratio between the distance d2 and the distance d1, comprised between 0.2 and 0.7, in such a way that the conductive filament (500) is formed in the second zone (302).

16. Method according to any of the two preceding claims, wherein the step of forming the oxide layer (300) carried out in such a way that the oxide layer (300) has a first zone (301) and a second zone (302) comprises at least the following steps:
- the formation of an oxide layer (300) on one electrode among the first and second electrodes (100, 200);
- a step of thinning the oxide layer (300) in such a way as to form the second zone (302);
with the method then comprising the deposit of the other electrode among the first and second electrodes (100, 200) on the oxide layer (300), preferably the thickness of the oxide layer (300), after the step of thinning and on the second zone (302), having a thickness equal to the minimum distance d2.

17. Method according to any of claims 14 to 15, wherein the step of forming the oxide layer (300) carried out in such a way that the oxide layer (300) has a first zone (301) and a second zone (302) comprises at least the following steps:
- the formation of a first oxide layer (310) on one electrode among the first and second electrodes (100, 200);
- the removal of all of the thickness of the first oxide layer (310) only on the second zone (302) in such a way as to expose said electrode from among the first and second electrodes (100, 200) on the second zone (302);
- the deposit of a second oxide layer (320) on the first oxide layer (310) and on said electrode among the first and second electrodes (100, 200) exposed on the second zone (302);
with the method then comprising the deposit of the other electrode among the first and second electrodes (100, 200), preferably the thickness of the second oxide layer such as deposited is equal to the minimum distance d2.

18. Method according to claim 14, wherein
- the step of forming the oxide layer (300) carried out in such a way that the oxide layer (300) has a first zone (301) and a second zone (302) comprises at least the formation of a first oxide layer (310) on one electrode among the first and second electrodes (100, 200);
- the formation of at least one masking layer (2100, 2200, 2300) and the carrying out of guiding patterns (3000) in the masking layer (2100, 2200, 2300);
- the depositing of a diblock copolymer (4000) in the guiding patterns (3000), with the diblock copolymer (4000) being able to form in each guiding pattern (3000) a first polymer (4100) and a second polymer (4200), with the first polymer (4100) surrounding the or being located on either side of the second polymer (4200);
- the complete removal of the second polymer (4200) by leaving in place the first polymer (4100) in such a way as to form a hollow pattern (3500) facing with the oxide layer (300);
- the etching of the oxide layer (300) located straight with the hollow pattern (3500);
- the removal of the first polymer (4100);
- the formation of the other electrode among the first and second electrodes (100, 200);

19. Method according to the preceding claim, wherein the step of etching the oxide layer (300) located straight with the hollow pattern (3500) is carried out either in such a way as to etch only partially the thickness of the oxide layer (300) and to retain a portion of the thickness of the oxide layer (300), with this portion of thickness defining the minimum distance d2, either in such a way as to etch entirely the thickness of the oxide layer (300) in such a way as to expose the electrode whereon the oxide layer (300) rests in a zone intended to form the second zone (302); the method, according to this second alternative comprising, after the removal of the first polymer (4100) and before the formation of the other electrode among the first and second electrodes (100, 200), a step of depositing another oxide layer, in particular in the zone intended to form the second zone (302), with the thickness of said other oxide layer defining the minimum distance d2.

20. Microelectronic device comprising a plurality of memory devices according to any of claims 1 to 13.
